(19)

**Europäisches Patentamt**
**European Patent Office**
**Office européen des brevets**

(11) **EP 3 155 776 B1**

(12) **EUROPEAN PATENT SPECIFICATION**

(45) Date of publication and mention
of the grant of the patent:
**02.11.2022 Bulletin 2022/44**

(21) Application number: **15806065.7**

(22) Date of filing: **12.06.2015**

(51) International Patent Classification (IPC):
*H03F 1/32* (2006.01)   *H03F 3/195* (2006.01)
*H03F 3/24* (2006.01)   *H03F 3/68* (2006.01)
*H04B 1/04* (2006.01)   *H04L 25/03* (2006.01)
*H04L 27/26* (2006.01)   *H04L 27/36* (2006.01)

(52) Cooperative Patent Classification (CPC):
**H03F 3/195; H03F 1/3241; H03F 1/3247;**
**H03F 1/3258; H03F 3/245; H03F 3/68;**
**H04B 1/0475; H04L 25/03343;** H03F 2200/111;
H03F 2201/3236; H04B 2001/0425; H04L 27/2626

(86) International application number:
**PCT/US2015/035707**

(87) International publication number:
**WO 2015/192112 (17.12.2015 Gazette 2015/50)**

(54) **MULTICARRIER SUCCESSIVE PREDISTORTION FOR DIGITAL TRANSMISSION**

SUKZESSIVE MEHRTRÄGERVORVERZERRUNG FÜR DIGITALE ÜBERTRAGUNG

PRÉDISTORSION SUCCESSIVE MULTIPORTEUSE POUR ÉMISSION NUMÉRIQUE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **12.06.2014 US 201462011567 P**
**31.03.2015 US 201514675735**

(43) Date of publication of application:
**19.04.2017 Bulletin 2017/16**

(73) Proprietor: **Hughes Network Systems, LLC**
**Germantown, MD 20876 (US)**

(72) Inventors:
• **BEIDAS, Bassel**
**Alexandria, VA 22304 (US)**
• **SESHADRI, Rohit Iyer**
**Gaithersburg, MD 20878 (US)**
• **BECKER, Neal**
**Olney, MD 20832 (US)**

(74) Representative: **Körfer, Thomas**
**Mitscherlich PartmbB**
**Patent- und Rechtsanwälte**
**Sonnenstrasse 33**
**80331 München (DE)**

(56) References cited:
**EP-A1- 2 178 205**   **US-A1- 2002 164 949**
**US-A1- 2011 103 507**   **US-A1- 2011 103 507**
**US-A1- 2012 027 070**   **US-A1- 2014 079 160**
**US-A1- 2015 010 118**

• **ROBERTO PIAZZA ET AL: "Multicarrier digital**
**pre-distortion/ equalization techniques for**
**non-linear satellite channels", 30TH AIAA**
**INTERNATIONAL COMMUNICATIONS**
**SATELLITE SYSTEM CONFERENCE (ICSSC), 24**
**September 2012 (2012-09-24), page 1,**
**XP055183100, Reston, Virginia DOI:**
**10.2514/6.2012-15156 ISBN: 978-1-62-410242-4**
• **PIAZZA ROBERTO ET AL: "Data predistortion for**
**multicarrier satellite channels using orthogonal**
**memory polynomials", 2013 IEEE 14TH**
**WORKSHOP ON SIGNAL PROCESSING**
**ADVANCES IN WIRELESS COMMUNICATIONS**
**(SPAWC), IEEE, 16 June 2013 (2013-06-16), pages**
**689-693, XP032490449, ISSN: 1948-3244, DOI:**
**10.1109/SPAWC.2013.6612138 [retrieved on**
**2013-09-25]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND

Satellite communication systems must transmit signals vast distances from earth to satellites in orbit and vice versa. Additionally, satellites have strict power consumption limits that require the communication systems to operate at very high efficiencies of both power use and usage of available communication bandwidth. Many satellites use high power amplifiers (HPAs) for communication purposes. Typically, HPAs operate most efficiently at (or near) saturation. Unfortunately, operation of HPAs at (or near) saturation can lead to inter-symbol interference (ISI) in output channels. The output of a transmitter can be seen as a sequence of symbols called a phrase. Each symbol represents a sequence of bits, in the case of 8*PSK,* each symbol represents 3 bits. A transmitter will output the phrase one symbol at a time during transmission. As a transmitter shifts from one symbol to the next in the phrase, previous and future output symbols may cause interference in the output of the current symbol. This interference in the current symbol caused by past and future symbols is ISI.

In current satellite communications systems, the uplinked signal is amplified and channelized in a transparent satellite transponder. Further, to satisfy the aggressive demand for higher satellite throughput, industry trend is moving towards sharing the transponder amplifier by multiple carriers, each employing high-order modulations that are spectrally compact. Joint amplification of multiple-carrier signals using a common HPA is also employed to meet satellite power and mass requirements. Given the inherently nonlinear nature of the amplifier when driven efficiently closer to saturation, however, the amplification of multiple carriers through a common HPA further exacerbates the issue of intermodulation distortion that needs to be appropriately compensated. The non-linear effects are even more prominent in this scenario due to onset of such intermodulation products causing adjacent channel interference (ACI). A significant guard-band between the carriers may be needed in order to avoid ACI, thereby reducing spectral efficiency. Additionally, use of multiple carriers leads to high peak to average power ratios, which increases the back-off leading an amplification efficiency loss. Moreover, on-board channelization filters (IMUX/OMUX) introduce inter-symbol interference (ISI), which further degrades the performance. In order to mitigate the nonlinear distortion, significant back off is required, leading to power efficiency loss.

Improved technological solutions are needed to satisfy the aggressive demand for satellite throughput in broadband and broadcasting applications. The key is to maximize system efficiency at many levels, such as payload mass efficiency through sharing each satellite HPA (i.e., travelling-wave tube amplifier (TWTA)) by multiple carriers, bandwidth efficiency by employing frequency-compact carriers with high-order modulations using Amplitude and Phase Shift Keying (APSK) that are tightly packed in the spectrum, and power efficiency by properly operating the TWTA close to saturation. Due to the inherently nonlinear nature of TWTAs, this creates an environment with substantial nonlinear distortion that is significantly detrimental to system performance if left uncompensated.

Towards the goal of mitigating the nonlinear distortion, the articles (1) B. F. Beidas and R. I. Seshadri, "Analysis and compensation for nonlinear interference of two high-order modulation carriers over satellite link," IEEE Trans. Comm., vol. 58, no. 6, pp. 1824-1833, June 2010, and (2) B. F. Beidas, "Intermodulation distortion in multicarrier satellite systems: Analysis and turbo volterra equalization," IEEE Trans. Comm., vol. 59, no. 6, pp. 1580-1590, June 2011 provide an analytical framework that characterizes intermodulation distortion (IMD) resulting from such scenarios. The article (2) investigates receiver algorithms based on Turbo Volterra processing, where soft information between decoders and multicarrier Volterra equalizer is exchanged to progressively improve performance. Further, the articles (3) X. Wang and H. V. Poor, "Iterative (Turbo) soft interference cancellation and decoding for coded CDMA," IEEE Trans. Comm., vol. 47, no. 7, pp. 1046-1061, July 1999, (4) H. EI-Gamal and E. Geraniotis, "Iterative multiuser detection for coded CDMA in AWGN and fading channels," IEEE J. Select. Areas Comm., vol. 18, no. 1, pp. 30-41, January 2000, and (5) B. F. Beidas, H. EI-Gamal, and S. Kay, "Iterative interference cancellation for high spectral efficiency satellite communications," IEEE Trans. Comm., vol. 50, no. 1, pp. 31-36, January 2002 discuss the technology of multi-user detection (MUD) in nonlinear systems.

According to other current approaches, the articles (7) G. Karam and H. Sari, "Analysis of predistortion, equalization, and ISI cancellation techniques in digital radio systems with nonlinear transmit amplifiers," IEEE Trans. Comm., vol. 37, no. 12, pp. 1245-1253, December 1989, (8) L. Giugno, M. Luise, and V. Lottici, "Adaptive pre- and post-compensation of nonlinear distortions for high-level data modulations," IEEE Trans. Wireless Comm., vol. 3, no. 5, pp. 1490-1495, September 2004, and (9) R. De Gaudenzi, A. G. Fabregas, and A. Martinezi, "Performance analysis of turbo-coded APSK modulations over nonlinear satellite channels," IEEE Trans. Wireless Comm., vol. 5, no. 9, pp. 2396-2407, Sep. 2006 discuss static or memoryless data predistortion techniques that simplify attempts to correct for the constellation warping, without mitigating the nonlinear intersymbol interference (ISI). Also, the article (10) E. Biglieri, S. Barberis, and M. Catena, "Analysis and compensation of nonlinearities in digital transmission systems," IEEE J. Select. Areas Comm., vol. 6, no. 1, pp. 42-51, January 1988 proposes compensation based on $p^{th}$ order Volterra inverse of the nonlinearity, and article (11) C. Eun and E. Powers, "A new volterra predistorter based on the indirect learning architecture," IEEE Trans. Signal Process., vol. 45, no. 1, pp. 223-227, January 1997 introduces an adaptive version of the Volterra inverse. Further, predistortion based on nonlinear polynomial models is investigated in article (12) L. Ding, G. Zhou, D. Morgan, M. Zhengxiang, J. Kenney, K. Jaehyeong, and C. Giardina, "A robust digital baseband predistorter constructed using memory polynomials," IEEE Trans. Comm., vol. 52, no. 1, pp. 159-165, Jan. 2004. Dynamic data predistortion (based on look-up tables), generated by minimizing mean-squared error (MSE), is investigated in the articles (13) G. Karam and H. Sari, "A data predistortion technique with memory for QAM radio systems," IEEE Trans. Comm., vol. 39, no. 2, pp. 336-344, February 1991, and (14) E. Casini, R. De Gaudenzi, and A. Ginesi, "DVB-S2 modem algorithms design and performance over typical satellite channels," Int'l J. on Satellite Comm. and Networking, vol. 22, no. 2, pp. 281-318, 2004 - however, the size of LUTs grows exponentially with the modulation order and the memory span of the channel, both of which are large in efficient satellite systems. To avoid the use of LUTs, successive application of distortion cancellation is proposed in U.S. Patent No. 8,355,462, "System and method for combined predistortion and interference cancellation in a satellite communications system." With respect to multicarrier systems (where multiple carriers share the same nonlinearity), article (16) R. Piazza, M. R. Bhavani Shankar, E. Zenteno, D. Ronnow, J. Grotz, F. Zimmer, M. Grasslin, F. Heckmann, and S. Cioni, "Multicarrier digital predistortion/equalization techniques for nonlinear satellite channels," Proc. 30th AIAA Int'l Comm. Satellite System Conference (ICSSC), September 2012 proposes a multicarrier PD is proposed, which is based on modifying the transmitted symbols by a 3rd-order Volterra inverse of the nonlinearity and simplified using the memory polynomial approach of Reference (12). Avoiding the use of LUTs is particularly important in the multicarrier case as the size of LUTs grows exponentially not only with modulation order and memory span of the channel but also with the number of carriers.

US 2014/079160 A1 describes a system and methods that accommodate for nonlinear interference in a multicarrier communications system. This system and method comprises a transmitting path containing a plurality of signal sources, a plurality of encoders, a plurality of modulators, a plurality of filters and a plurality of transmitters. Multiple transmission paths are arranged in parallel without interaction. Therefore, the signal processing at a single transmission path is exemplarily described. The signal source outputs a source signal reflecting a sequence of source data symbols for transmission to the encoder. The encoder generates an encoded vector signal source signal. The modulator modulates the encoded vector signal into a Gray-coded Quadrature Amplitude Modulation (QAM) signal or Amplitude Phase Shift Keyed (APSK) modulated signal, wherein each source symbol is mapped to a respective signal constellation point of the signal constellation of the applied modulation scheme. The modulated signal is provided to the filter and generates a continuous filtered signal. This filter is designed as a pulse shaping filter. The filter may also be designed as a cascade of pulse-shaping filters and an on-board input multiplexing filter of a satellite.

EP 2 178 205 A1 shows a radio transmission system using multiple Volterra Engine linearizers. A plurality of Volterra Engine linearizers are coupled in a series architecture comprising a plurality of VE linearizers. The final Volterra Engine linearizers is coupled to a power amplifier. A feedback circuitry coupled to the Volterra Engine linearizers and the output of the power amplifier. At least one adaptive controller is coupled to the feedback circuitry to improve linearization efficiency and distortion compensation in the radio transmission system.

US 2002/0164949 A1 describes a satellite communication apparatus comprising a corrector for reducing distortion of a signal in a communication channel. The corrector is formed by a forward model representative of a precalculated estimate of non-linearity and group delay of the satellite transmission/reception channel from the input to the up sampler through to the output of the down sampler. The forward model may also comprise a model of magnitude response of a satellite input multiplexer filter and output multiplexer filter. Cascaded identical stages of the corrector may be provided so that distortion in the channel is successively reduced towards zero by each successive stage. The every independently predistorte channel is combined by a multiplexer to a multi channel signal without any further multi carrier predistortion.

As bandwidth demands continue to increase, system requirements are driven to new levels, such as requirements for further increased satellite throughput, improved spectral efficiency, further satellite power and mass optimization and further improved decoding capabilities of system terminal receivers (without driving the receiver complexity and processing burdens to inefficient and impractical levels). What is needed, therefore, are approaches that provide improved compensation for mitigating nonlinear distortion in such high throughput multicarrier satellite communications systems (employing HPAs that process composite multicarrier signals for transmission over respective satellite channels, where the HPAs operate at or near saturation), which can be deployed entirely at the transmitter or gateway.

BRIEF SUMMARY

The present invention advantageously addresses the foregoing requirements and needs, as well as others, by providing approaches for improved compensation for mitigating nonlinear distortion in such high throughput multicarrier satellite communications systems (employing HPAs that process composite multicarrier signals for transmission over respective satellite channels, where the HPAs operate at or near saturation), which can be deployed entirely at the transmitter or gateway.

Embodiments of the present invention provide powerful compensation techniques for mitigating the nonlinear distortion, which can be deployed entirely at the transmitter or gateway. By way of example, the transmission symbols are modified such that, upon reception, the received symbols exhibit a minimum amount of IMD-induced clustering. More specifically, embodiments of the present invention provide for a multicarrier data predistortion (PD) technique that comprises estimation of the distortion that would result from passing the transmission signal (reflecting a composite of the signals of each carrier that will share the transmission channel) through the nonlinear satellite channel. The distortion estimate is then used to generate an error signal that is driven to zero by applying the estimation in a successive staged manner. Further, the predistortion is applied by the gateway transmitter, prior to transmission of the carrier signals to the destination receivers. More specifically, the distortion determination is performed based on an estimation of the IMD effects (the inter-relational effects) of all adjacent carriers sharing the common channel (being processed together through the non-linear channel). While the determination takes into account such inter-relational effects of all the carriers, however, the error signal is driven to zero, and the predistortion is applied, for each carrier individually. Further, with the approaches of the present invention, a relatively simple single carrier receiver can be employed at the receiver end to receive the composite signal transmitted by the gateway via the multicarrier satellite channel, and to tune to and demodulate and decode the individual carrier signal destined for the respective terminal. As such, in view of the predistortion applied by the gateway to each individual carrier, the resulting carrier signal received by the destination terminal will already exhibit or reflect compensation for the IMD resulting from the transmission of the composite signal via a single satellite channel.

According to specific embodiments, two methods of estimating the distortion are provided, whereby one, which is corresponding to the claimed invention, is based on explicit implementation and one, which is not corresponding to the claimed invention, is based on a multicarrier Volterra approach (e.g., based on a Volterra approach as introduced by the above-referenced articles (1) and (2)). Further, embodiments of the present invention provide improvements over the PD method proposed by U.S. Patent No. 8,355,462, which is based on successive cancellation of nonlinear distortion in (i.e., in the case of multicarrier systems). Moreover, embodiments of the present invention avoid the use of LUTs. With regard to performance, extensive numerical studies have been conducted to evaluate the performance of the proposed multicarrier PD approaches of such embodiments of the present invention in a variety of scenarios when using high-order spectrally-efficient 16-APSK and 32-APSK modulations that are FEC-encoded with the LDPC codes of the DVB-S2 standard (ETSI EN 302 307). In accordance with such example embodiments, near-optimum performance is achieved (operating the HPAs/TWTAs close to saturation), even with the deployment of a simple linear receiver without exchange of data symbols between receivers.

In accordance with the invention as set forth in the claims that follow, a method and a corresponding transmitter apparatus are provided for improved compensation for mitigating nonlinear distortion in high throughput multicarrier satellite communications systems. A plurality of source signals are received, wherein each source signal reflects an encoded and modulated sequence of source data symbols. A final predistorted version of each source signal is generated, and a transmit filter is applied to the predistorted version of each of the source signals. Each of the filtered signals is then translated to a respective carrier frequency, and the translated signals are combined to generate a composite signal for transmission via a multicarrier satellite transponder. The final predistorted version of each of the source signals is generated via an iterative process of a number of stages, wherein, for a given stage and for each source signal, the process comprises: receiving a respective prior predistorted version of each of the source signals from a preceding stage; processing the prior predistorted version of the source signal based on all of the received prior predistorted versions of the source signals, wherein the processing of the prior predistorted version of the source signal is performed based on a characterization of one or more characteristics of the multicarrier satellite transponder.

Still other aspects, features, and advantages of the present invention are readily apparent from the following detailed description, simply by illustrating a number of particular embodiments and implementations, including the best mode contemplated for carrying out the present invention. The present invention is also capable of other and different embodiments, and its several details can be modified in various obvious respects, all without departing from the scope of the present invention as set forth in the claims that follow. Accordingly, the drawing and description are to be regarded as illustrative in nature, and not as restrictive.

BRIEF SUMMARY OF THE DRAWINGS

The accompanying drawings, which are incorporated in and form a part of the specification, illustrate an example embodiment of the present invention and, together with the description, serve to explain the principles of the invention. In the drawings:

FIG. 1 illustrates a multicarrier satellite communications system for employing predistortion approaches, in accordance with example embodiments;

FIG. 2 illustrates a block diagram depicting a transmitter in a multicarrier system, where $M_c$ independent source signals are to be transmitted over a single satellite channel;

FIG. 3 illustrates a block diagram depicting the multicarrier transmitter of FIG. 2, employing a multicarrier predistorter, in accordance with example embodiments;

FIG. 4 illustrates a block diagram depicting single carrier receivers, in accordance with example embodiments;

FIGs. 5A and 5B illustrate example frequency responses of the IMUX filter of FIGs. 2 and 3;

FIGs. 5C and 5D illustrate example frequency responses of the OMUX filter of FIGs. 2 and 3;

FIGs. 5E and 5F illustrate examples of the AM/AM characteristics reflecting the amplitude distortions and the AM/PM characteristics reflecting the phase distortions, respectively, introduced by the HPA of FIGs. 2 and 3;

FIG. 6A illustrates a block diagram depicting the multicarrier successive predistorter of FIG. 3, in accordance with example embodiments;

FIG. 6B illustrates a block diagram depicting the $S^{th}$ stage of the multicarrier successive predistorter of FIG. 6A, in accordance with example embodiments;

FIGs. 7A and 7B illustrate noiseless scattered diagrams comparing the desired received signal versus its reconstruction using the Volterra-based method; and

FIG. 8 illustrates a block diagram of a chip set that can be utilized in implementing example embodiments according to the present invention.

DETAILED DESCRIPTION

Approaches that provide improved compensation for mitigating nonlinear distortion in high throughput multicarrier satellite communications systems (employing HPAs that process composite multicarrier signals for transmission over respective satellite channels, where the HPAs operate at or near saturation), which can be deployed entirely at the transmitter or gateway, are described. In the following description, for the purposes of explanation, numerous specific details are set forth in order to provide a thorough understanding of the present invention. The present invention is not intended to be limited based on the described embodiments, and various modifications will be readily apparent. It will be apparent that the invention may be practiced without the specific details of the following description. Additionally, well-known structures and devices may be shown in block diagram form in order to avoid unnecessarily obscuring the invention. Further, the specific applications discussed herein are provided only as representative examples, and the principles described herein may be applied to other embodiments and applications without departing from the general scope of the present invention as set forth in the claims that follow.

As will be appreciated, a module or component (as referred to herein) may be composed of software component(s), which are stored in a memory or other computer-readable storage medium, and executed by one or more processors or CPUs of the respective devices. As will also be appreciated, however, a module may alternatively be composed of hardware component(s) or firmware component(s), or a combination of hardware, firmware and/or software components. Further, with respect to the various example embodiments described herein, while certain of the functions are described as being performed by certain components or modules (or combinations thereof), such descriptions are provided as examples and are thus not intended to be limiting. Accordingly, any such functions may be envisioned as being performed by other components or modules (or combinations thereof), without departing from the spirit and general scope of the present invention. Moreover, the methods, processes and approaches described herein may be processor-implemented using processing circuitry that may comprise one or more microprocessors, application specific integrated circuits (ASICs), field programmable gate arrays (FPGAs), or other devices operable to be configured or programmed to implement the systems and/or methods described herein. For implementation on such devices that are operable to execute software instructions, the flow diagrams and methods described herein may be implemented in processor instructions stored in a computer-readable medium, such as executable software stored in a computer memory store.

Further, terminology referring to computer-readable media or computer media or the like as used herein refers to any medium that participates in providing instructions to the processor of a computer or processor module or component for execution. Such a medium may take many forms, including but not limited to non-transitory non-volatile media and volatile media. Non-volatile media include, for example, optical disk media, magnetic disk media or electrical disk media (e.g., solid state disk or SDD). Volatile media include dynamic memory, such random access memory or RAM. Common forms of computer-readable media include, for example, floppy or flexible disk, hard disk, magnetic tape, any other magnetic medium, CD ROM, CDRW, DVD, any other optical medium, random access memory (RAM), programmable read only memory (PROM), erasable PROM, flash EPROM, any other memory chip or cartridge, or any other medium from which a computer can read data.

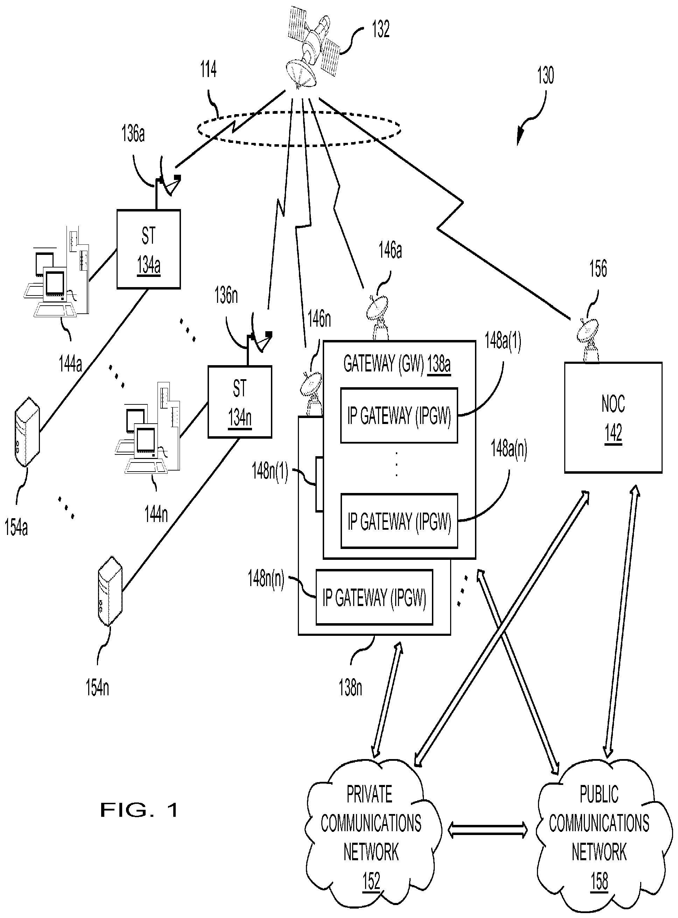

FIG. 1 illustrates an example satellite communications system 130 capable of supporting communications among terminals with varied capabilities, according to example embodiments. Satellite communications system 130 includes a satellite 132 that supports communications among multiple satellite terminals (STs) 134a-134n, a number of gateways (GWs) 138a-138n, and a network operations center (NOC) 142. The STs, GWs and NOC transmit and receive signals via the antennas 136a-136n, 146a-146n, and 156, respectively. According to different embodiments, the NOC 142 may reside at a separate site reachable via a separate satellite channel or may reside within a GW site. The NOC 142 performs the management plane functions of the system 130, while the GWs 138a-138n perform the data plane functions of the system 130. For example, the NOC 142 performs such functions as network management and configuration, software downloads (e.g., to the STs 134a-134n), status monitoring, statistics functions (e.g., collection, aggregation and reporting), security functions (e.g., key generation, management and distribution), ST registration and authentication, and GW diversity management. The NOC 142 communicates with each GW via the satellite 132, or via a secure private communications network 152 (e.g., an IPsec tunnel over a dedicated link or a virtual private network (VPN) or IPsec tunnel through a public network, such as the Internet). It should be noted that, according to one example embodiment, the traffic classification approaches of embodiments of the present invention address classification of data traffic flowing through an aggregation point or node. Additionally, each GW and the NOC have connectivity to one or more public communications networks, such as the Internet or a PSTN.

According to a further example embodiment, each of the GWs 138a-138n include one or more IP gateways (IPGWs) - whereby the data plane functions are divided between a GW and its respective IPGWs. For example, GW 138a includes IPGWs 148a(1)-148a(n) and GW 138n includes IPGWs 148n(1)-148n(n). A GW may perform such functions as link layer and physical layer outroute coding and modulation (e.g., DVB-S2 adaptive coding and modulation), link layer and physical layer inroute handling (e.g., IPOS), inroute bandwidth allocation and load balancing, outroute prioritization, web acceleration and HTTP compression, flow control, encryption, redundancy switchovers, and traffic restriction policy enforcement. Whereas, the IPGW may perform such functions as data compression, TCP performance enhancements (e.g., TCP performance enhancing proxies, such as TCP spoofing), quality of service functions (e.g., classification, prioritization, differentiation, random early detection (RED), TCP/UDP flow control), bandwidth usage policing, dynamic load balancing, and routing. Further, a GW and respective IPGW may be collocated with the NOC 142. The STs 134a-134n provide connectivity to one or more hosts 144a-144n and/or routers 154a-154n, respectively. The Satellite communications system 130 may operate as a bent-pipe system, where the satellite essentially operates as a repeater or bent pipe. Alternatively, the system 130 may employ a switching or processing satellite supporting mesh communications (point-to-point communications directly between, for example, the two STs 134a and 134n).

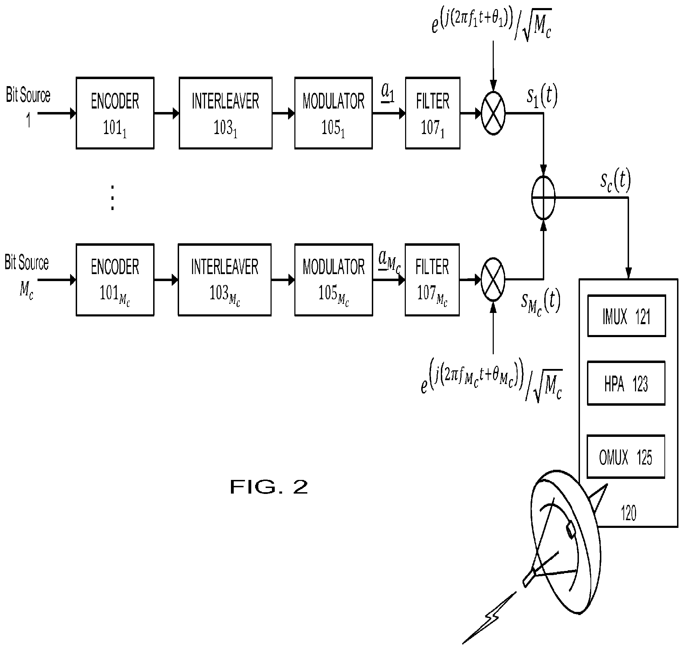

FIG. 2 illustrates a block diagram depicting a transmitter in a multicarrier system, where $M_c$ independent source signals are to be transmitted over a single satellite channel. Each independent bit source, 1, ..., $M_c$, is FEC encoded via the respective encoder $101_1$, ...,$101_{Mc}$, interleaved via the respective interleaver $103_1$,...,$103_{Mc}$, and mapped onto a two dimensional *M-ary* constellation (e.g., QPSK, 8PSK, 16APSK., etc.) by the respective modulator $105_1$,...,$105_{Mc}$. The resulting signals $\underline{a}_1$, ...,$\underline{a}_{Mc}$ reflect the complex-valued symbol sequences $\{a_{m,k}; k = 0,1, ..., N - 1; m = 1,2,..., M_c\}$ at the symbol rate $T_s^{-1}$. The resulting symbol sequences are processed by the respective transmit pulse-shaping filters $107_1$,...,$107_{Mc}$, with respective impulse responses $p_{1,T}(t)$,...,$p_{Mc,T}(t)$ to generate the respective baseband modulated signals:

$$s_m(t) = \sum_k a_{m,k} \cdot p_{m,T}(t - kT_s) \qquad (1)$$

Where $T_s$ is the symbol period.

Each signal is then frequency-translated to its respective slot or center frequency and combined, where the composite signal can then be described as:

$$s_c(t) = \sum_k s_m(t) \frac{exp\big(j(2\pi f_m t + \theta_m)\big)}{\sqrt{M_c}} \qquad (2)$$

where $f_m$ and $\theta_m$ are the center frequency and carrier phase of the $m^{th}$ channel, respectively. According to one embodiment, for better utilization of bandwidth, the case of a uniform spacing in frequency ($\Delta f$) is considered, but in other embodiments the techniques of the present invention may be applied to any frequency plan. Also, according to this embodiment, $p_{m,T}$ is the transmit pulse shaping filter.

The signal composite of equation (2) is then processed by the satellite transponder 120, which includes an input multiplexing (IMUX) filter 121, a nonlinear traveling wave tube amplifier (TWTA) or high power amplifier (HPA) 123, and an output multiplexing (OMUX) filter 125. The IMUX filter selects the desired group of $M_c$ carriers, thereby limiting the impact of adjacent uplink carriers. The OMUX filter follows the TWTA and is used to limit nonlinear interference to adjacent transponders. According to one embodiment, the frequency response associated with the IMUX and OMUX are obtained by using a scaling formula of the corresponding filter responses (as detailed in the ETSI DVB-S2 standard, ETSI EN 302 307) with a scale factor of $M_c$, or

$$R'(f) = R(f/M_c) \tag{3}$$

$$G'(f) = \frac{1}{M_c} \cdot G(f/M_c) \tag{4}$$

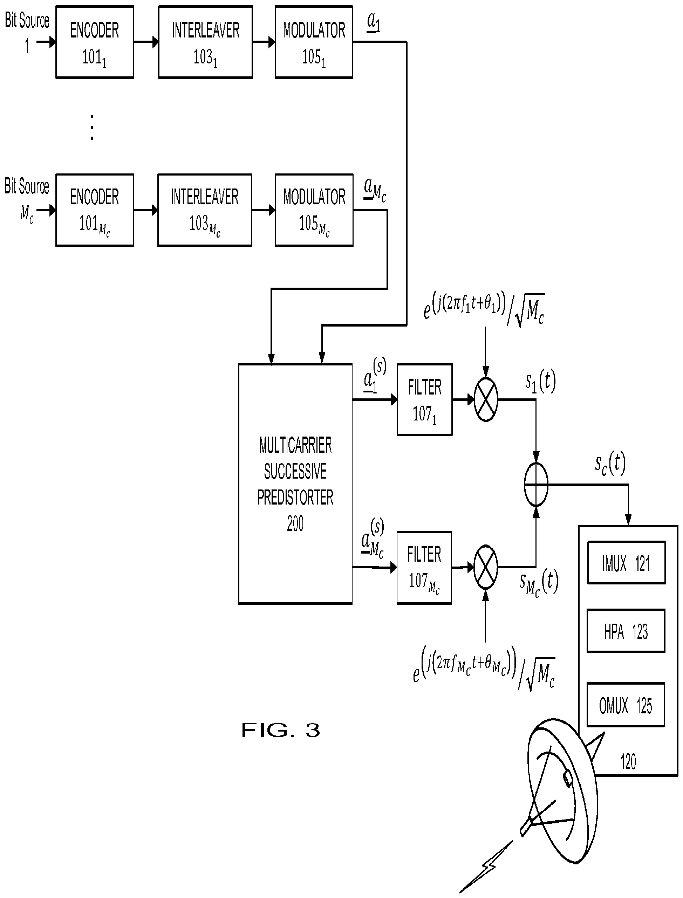

FIG. 3 illustrates a block diagram depicting the multicarrier transmitter of FIG. 2, employing a multicarrier predistorter, in accordance with example embodiments. With reference to FIG. 3, the like numbered blocks perform the same functions, and thus the associated description will not be repeated here. The multicarrier transmitter of FIG. 3 includes the multicarrier successive predistorter 200, which predistorts the signal sequences via successive stages. The complex-valued symbol sequences output from the modulators, $105_1,...,105_{Mc}$ $\{a_{m,k}; k = 0,1,...,N - 1; m = 1, 2,...,M_c\}$, are fed into the multicarrier predistorter, and the output of the successive predistorter (with S stages) is given by

$$\left\{ a_{m,k}^{(s)}; k = 0, 1, ..., N - 1; m = 1, 2, ..., M_c \right\}$$ , which is also at the symbol rate $T_s^{-1}$ .

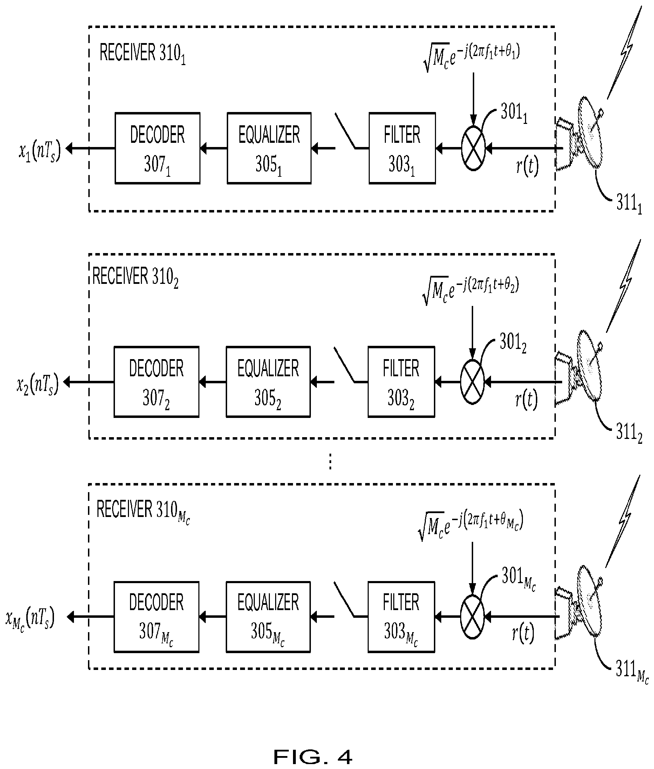

FIG. 4 illustrates a block diagram depicting single carrier receivers $310_1$, $310_2$, ..., $310_{Mc}$, in accordance with example embodiments. The receivers may be co-located or at geographically different locations. Each receiver receives the transmitted signal as the received signal r(t) received via the receiver antenna 311. Each receiver tunes to the carrier and phase of the respective carrier signal destined for that receiver. In this example, the carrier signal $s_1(t)$ is destined for the receiver $310_1$ ... the carrier signal $s_{Mc}(t)$ is destined for the receiver $310_{Mc}$. The down-converters ($301_1$, $301_2$, ..., $301_{Mc}$) translate or convert each of the receive carrier signals from the respective carrier frequency to a baseband complex signal centered at zero frequency. The down-converted baseband signals are fed to the respective receive filters $303_1$, $303_2$, ..., $303_{Mc}$, with the respective impulse responses $p_{1,R}(t)$, $p_{2,R}(t)$, ... , $p_{Mc,R}(t)$. The signal at the each receiver filter output can be expressed as:

$$x_m(t) = \int_{-\infty}^{\infty} r(t - \tau)\sqrt{M_c}\, e^{-j(2\pi f_m(t-\tau)+\theta_m)} \cdot p_{n,R}(\tau)\,d\tau. \tag{5}$$

According to one embodiment, the signal $x_m(t)$ from each filter is then sampled at multiples of the symbol rate. By way of example, at the output of the sampler, the samples are at symbol rate $x_m(nT_s)$. Next, each of the equalizers $305_1, 305_2, ... , 305_{Mc}$ is employed for equalizing the sample outputs from the respective sampler to compensate for the impact of IMUX and OMUX filters of the satellite transponder. By way of example, fractionally-spaced equalization may be employed to compensate for the linear distortion introduced by the IMUX and OMUX filters. Each equalizer output (e.g., $y_m((n + \varepsilon_m)T_s)$) is utilized to generate log-likelihood ratios, which are passed to the respective decoder. Each of the decoders $307_1$, $307_2$, ..., $307_{Mc}$ utilizes the log-likelihood ratios for a determination of the respective transmitted signal constellation points, and from there determines the corresponding source symbol and code-bits based on the received signal.

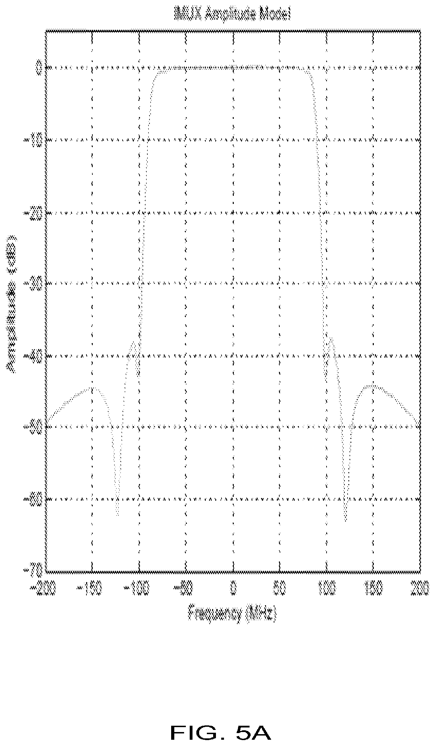

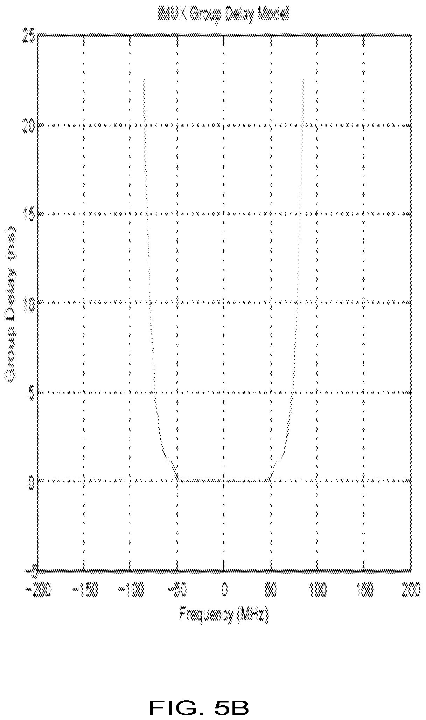

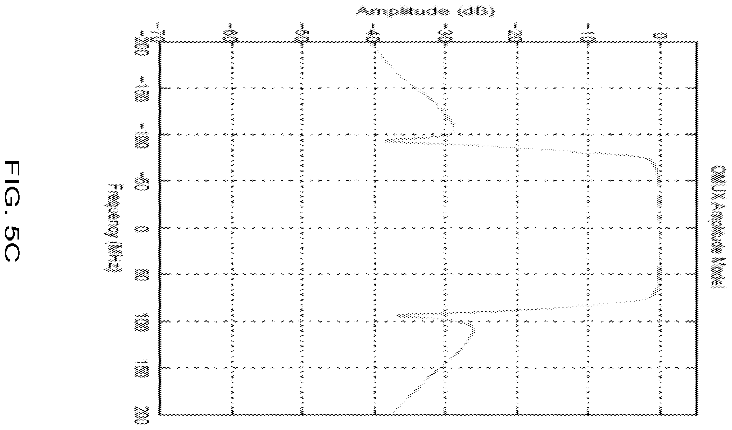

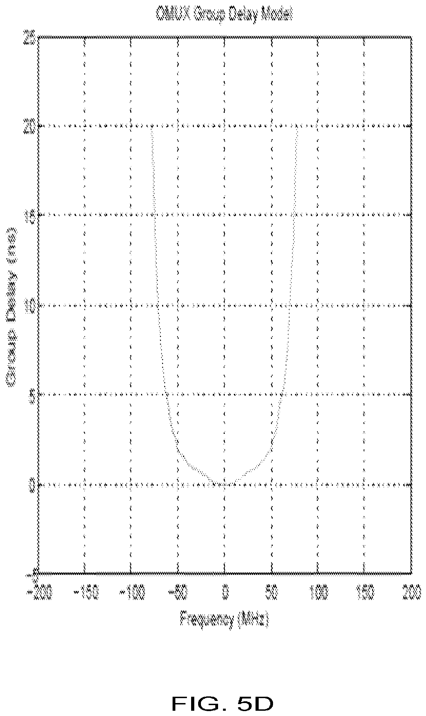

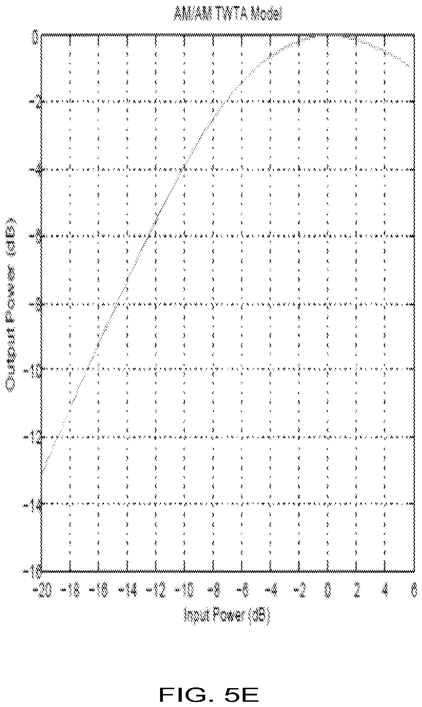

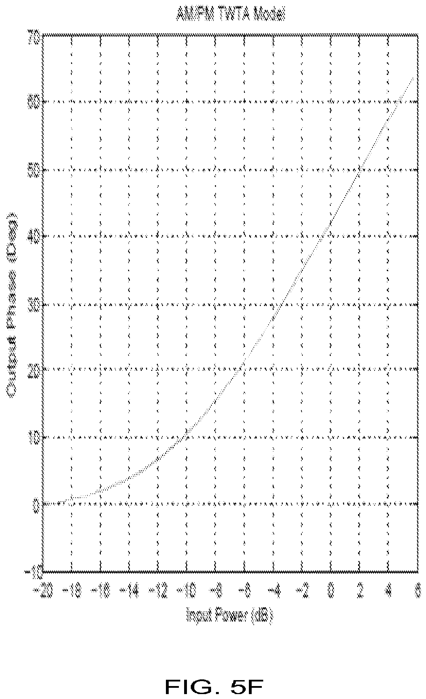

FIGs. 5A and 5B show example frequency responses of the IMUX filter of FIGs. 2 and 3, and FIGs. 5C and 5D show example frequency responses of the OMUX filter of FIGs. 2 and 3, all for the case of $M_c$ = 4. Further, FIGs. 5E and 5F show examples of the AM/AM characteristics reflecting the amplitude distortions and the AM/PM characteristics reflecting the phase distortions, respectively, introduced by the HPA of FIGs. 2 and 3. Downlink noise n(t) is AWGN with single-sided power spectral density of $N_0$ (Watt/Hz), which corrupts the signal at the OMUX output, such that the received signal can be denoted as:

$$r(t) = s_{OMUX}(t) + n(t) \qquad\qquad (6)$$

## I. MULTICARRIER SUCCESSIVE PREDISTORTION

In accordance with example embodiments, with regard to the successive multicarrier predistorter 200 of FIG. 3, novel predistortion approaches are provided. Such approaches provide powerful non-linear distortion compensation techniques that can be deployed entirely at the transmitter or gateway (e.g., the gateways 138 of FIG. 1). Such non-linear distortion compensation techniques mitigate and compensate for the adverse impact of nonlinear distortion that results when a single satellite TWTA or HPA is shared by multiple carriers. Further, such approaches contemplate the situation of achieving high-bandwidth efficiency where the carriers employ high-order modulation, and the satellite TWTA is operated near saturation. By way of example, at a system gateway, the transmission symbols of each bit source are modified such that, upon reception, the received symbols exhibit a minimum amount of IMD-induced clustering (resulting from the processing through a common non-linear satellite channel). More specifically, embodiments of the present invention provide for a multicarrier predistortion (PD) technique that comprises estimation of the distortion that would result from passing the transmission signal (reflecting a composite of the signals of each carrier that will share the transmission channel) through the nonlinear satellite channel. The distortion estimate is then used to generate an error signal that is driven to zero by applying the estimation in a successive staged manner. Further, the predistortion is applied by the gateway transmitter, prior to transmission of the carrier signals to the destination receivers. More specifically, the distortion determination is performed based on an estimation of the IMD effects (the inter-relational effects) of all adjacent carriers sharing the common channel (being processed together through the non-linear channel). While the determination takes into account such inter-relational effects of all the carriers, however, the error signal is driven to zero, and the predistortion is applied, for each carrier individually. Further, with the approaches of the present invention, a relatively simple single carrier receiver can be employed at the receiver end to receive the composite signal transmitted by the gateway via the multicarrier satellite channel, and to tune to and demodulate and decode the individual carrier signal destined for the respective terminal. As such, in view of the predistortion applied by the gateway to each individual carrier, the resulting carrier signal received by the destination terminal will already exhibit or reflect compensation for the IMD resulting from the transmission of the composite signal via a single satellite channel.

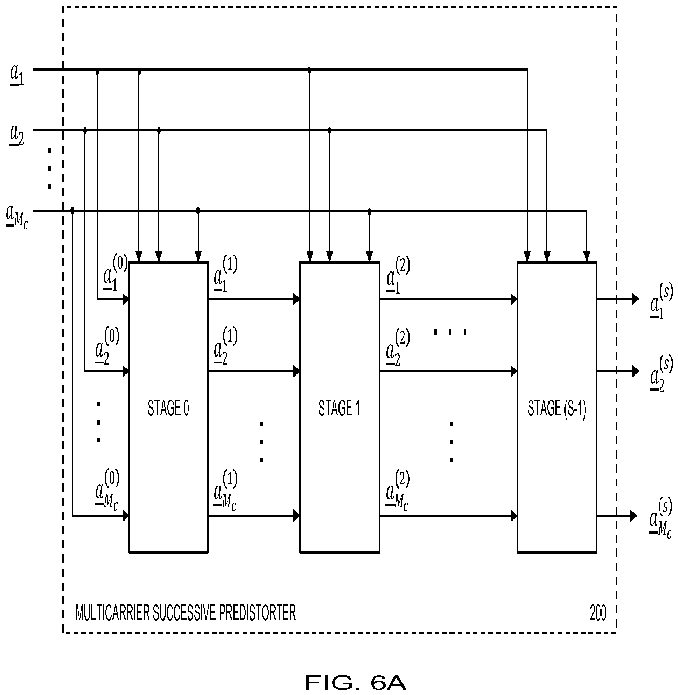

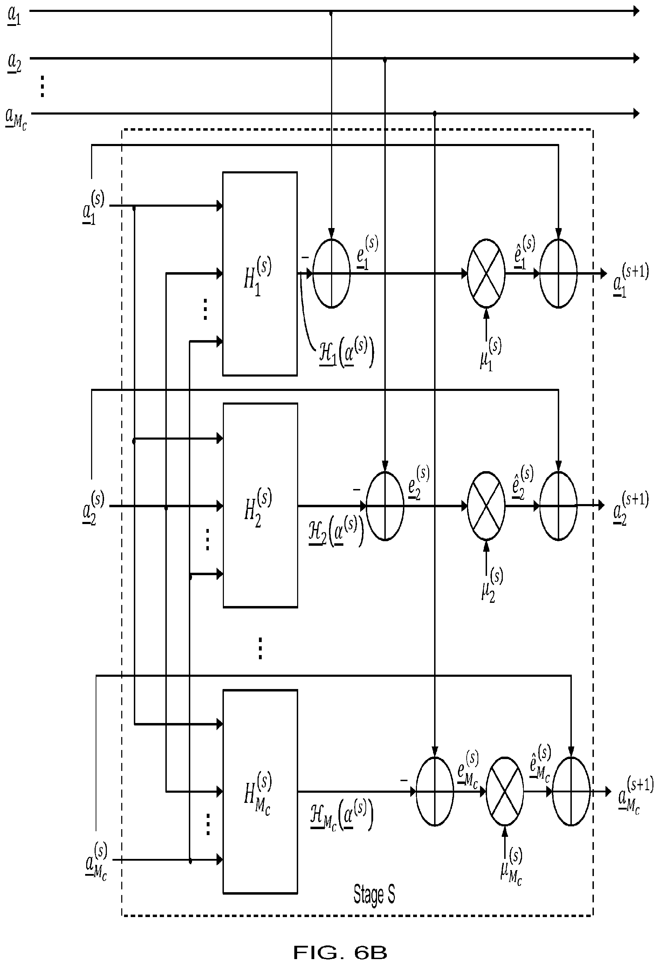

FIG. 6A illustrates a block diagram depicting the multicarrier successive predistorter 200 of FIG. 3, in accordance with example embodiments, and FIG. 6B illustrates a block diagram depicting the $s^{th}$ stage of the multicarrier successive predistorter of FIG. 6A, in accordance with example embodiments. As discussed above, the predistortion techniques of the example embodiments of the present invention are applied in the sequential staged manner.

With reference to FIG. 6A, a formulation is developed whereby the predistorter 200 applies an estimated predistortion (successively in stages) to the vector of input symbols $\underline{a}_m^{(s)}$. The input vector $\underline{a}_m^{(s)}$ comprises a vector of predistorted symbols from the previous stage of the predistorter, which reflects a vector of complex-valued data symbols associated with the $m^{th}$ carrier at the $s^{th}$ stage, which can be denoted as:

$$\underline{a}_m^{(s)} = \left[ a_{m,0}^{(s)} \ a_{m,1}^{(s)} \ ... \ a_{m,N-1}^{(s)} \right]^T, \qquad\qquad (7)$$

where $s = (0,1,...,S - 1)$, $1 \le m \le M_c$, and $N$ is the length of the data block (which typically spans a codeword). For the first stage (where there is no estimate from a previous stage), the predistoerter vector input is composed of the undistorted vector of data symbols $\underline{a}_1, \underline{a}_2, ... , \underline{a}_{Mc}$, which is represented in FIG. 6A as:

$$\underline{a}_m^{(0)} = \underline{a}_m = \left[ a_{m,0} \ a_{m,1} \ ... \ a_{m,N-1} \right]^T. \qquad\qquad (8)$$

Accordingly, as depicted in FIG. 6A, at Stage 0, the predistorter applies an estimated predistortion to the vector of input symbols $\underline{a}_m^{(0)} = \left[ \underline{a}_1^{(0)} \ \underline{a}_2^{(0)} \ ... \ \underline{a}_{M_c}^{(0)} \right]$ (which is the undistorted vector of data symbols $\underline{a}_1; \underline{a}_2, ..., \underline{a}_{Mc}$). At Stage 1, the predistorter applies an estimated predistortion to the vector of input symbols $\underline{a}_m^{(1)} = \left[ \underline{a}_1^{(1)} \ \underline{a}_2^{(1)} \ ... \ \underline{a}_{M_c}^{(1)} \right]$ (which is the distorted vector of data symbols output from Stage 0. At the last Stage (s-1), the predistorter applies an estimated predistortion to the vector of input symbols $\underline{a}_m^{(s)} = \left[\underline{a}_1^{(s)} \ \underline{a}_2^{(s)} \ ... \ \underline{a}_{M_c}^{(s)}\right]$ (which is the distorted vector of data symbols output from Stage (s-2). The final output of the predistorter is the final predistorted data symbol vectors $\underline{a}_1^{(s)}, \underline{a}_2^{(s)}, ..., \underline{a}_{M_c}^{(s)}$ that are forwarded to the respective filters $107_1, ..., 107_{Mc}$.

Further, a vector of symbols $\underline{\alpha}^{(s)}$, composed of the corresponding vector of symbols associated with each one of the $M_c$ carriers sharing the nonlinearity, can be denoted as:

$$\underline{\alpha}^{(s)} = \begin{bmatrix} \underline{a}_1^{(s)} \\ \underline{a}_2^{(s)} \\ \vdots \\ \underline{a}_{M_c}^{(s)} \end{bmatrix} \tag{9}$$

The vector $\underline{\mathcal{H}}_{m_d}\left(\underline{\alpha}^{(s)}\right)$, of length $N$, reflects the estimate of distortion experienced by a specific $m_d^{th}$ carrier (where $1 \le m_d \le M_c$), using the vector $\underline{\alpha}^{(s)}$ for the $s^{th}$ stage defined by equation (9). With reference to FIG. 6B, the vector $\underline{\mathcal{H}}_{m_d}\left(\underline{\alpha}^{(s)}\right)$ for the $s^{th}$ stage is $\left[\underline{\mathcal{H}}_1\left(\underline{\alpha}^{(s)}\right) \ \underline{\mathcal{H}}_2\left(\underline{\alpha}^{(s)}\right) ... \underline{\mathcal{H}}_{M_c}\left(\underline{\alpha}^{(s)}\right)\right]$, where $\underline{\mathcal{H}}_1\left(\underline{\alpha}^{(s)}\right), \underline{\mathcal{H}}_2\left(\underline{\alpha}^{(s)}\right), ..., \underline{\mathcal{H}}_{M_c}\left(\underline{\alpha}^{(s)}\right)$ are the outputs of the processing elements $H_1^{(s)}, H_2^{(s)}, ..., H_{M_c}^{(s)}$ of the $s^{th}$ stage depicted in FIG. 6B. According to example embodiments, the determination of the vector $\underline{\mathcal{H}}_{m_d}\left(\underline{\alpha}^{(s)}\right)$ is discussed in further detail below in the context of two example approaches.

The distortion estimate is then utilized to generate an error vector relative to the undistorted constellation, individually, for each carrier $m_d = 1, 2, ..., M_c$, by subtracting the vector $\underline{\mathcal{H}}_{m_d}\left(\underline{\alpha}^{(s)}\right)$ for each carrier from the respective input vector $\underline{a}_{md}$, as follows:

$$\underline{e}_{m_d}^{(s)} = \underline{a}_{m_d} - \underline{\mathcal{H}}_{m_d}\left(\underline{\alpha}^{(s)}\right). \tag{10}$$

Accordingly, for each stage, the vector $\underline{a}^{(s)}$ takes into consideration the predistorted symbol vector of all carriers from the previous stage $\underline{a}_{m_d}^{(s)}$ (per equation (9), above). Further, for each stage, the vector $\underline{a}^{(s)}$ is used to determine the respective error vector for each individual carrier $\underline{e}_{m_d}^{(s)}$ (per equation (10), above). For each individual carrier, the predistortion determination processing for each stage thereby accounts for the predistortion estimates (from the previous stage) for all carriers.

The error vector in equation (10) is driven to zero by the successive application of the predistortion. By way of example, the predistortion output can be generated by modifying the predistorted symbols from the previous stage with a correction term that is proportional to the error vector. More specifically, at each stage, the error vector for each carrier $\underline{e}_{m_d}^{(s)}$ is processed based on a step-size factor or sequence $\mu_{m_d}^{(s)}$. By way of example, with further reference to FIG. 6B, for each carrier, the error vector $\underline{e}_{m_d}^{(s)}$ is multiplied by the step-size sequence to generate the modified error vector $\underline{\hat{e}}_{m_d}^{(s)}$. Finally, the predistortion output at the $s^{th}$ stage for the desired $m_d^{th}$ carrier is generated by adding the modified error vector $\underline{\hat{e}}_{m_d}^{(s)}$ to the predistorted symbol vector from the previous stage, as follows:

$$\underline{a}_{m_d}^{(s+1)} = \underline{a}_{m_d}^{(s)} + \mu_{m_d}^{(s)} \cdot \underline{e}_{m_d}^{(s)} , \tag{11}$$

where $\mu_{m_d}^{(s)}$ reflects an adaptation constant (which can be different for each stage), and where $1 \leq m_d \leq M_c$.

The step-size sequence is defined to satisfy certain conditions, including being positive and decreasing, to ensure progress toward a solution. Further, the step-size sequence serves to optimize the performance of the predistortion process by maximizing convergence speed (reduction of the number of predistoerter stages) while minimizing residual error. With respect to the maximization of convergence speed and the minimization of residual error, these concepts are in the context of a tradeoff between a practical or efficient processing time (a practical number of stages) and an acceptable level of performance (reduction of the residual error to an acceptable level so as not to pose a significant adverse effect on performance). In other words, the sequence $\mu_{m_d}^{(s)}$ is designed to achieve an acceptable and practical compromise between convergence speed and amount of residual error.

In accordance with example embodiments, the predistortion techniques include two approaches for determining an estimate of the distortion $\underline{\mathcal{H}}_{m_d}(\underline{\alpha}^{(s)})$ experienced by a specific $m_d^{th}$ carrier. At each stage (Stage S), the determination of the distortion estimate vector $\underline{\mathcal{H}}_{m_d}(\underline{\alpha}^{(s)})$ for each carrier is performed by the respective processing element $H_{m_d}^{(s)}$ (e.g., for the $s^{th}$ stage, the respective one of the processing elements $H_1^{(s)}, H_2^{(s)}, \ldots, H_{M_c}^{(s)}$ depicted in FIG. 6B). According to such embodiments, these techniques comprise an explicit implementation, which is corresponding to the claimed invention, and a Volterra-based approach, which is not corresponding to the claimed invention.

A. Explicit Approach

According to a first approach, which is corresponding to the claimed invention, the explicit method of implementing the distortion estimation $\underline{\mathcal{H}}_{m_d}(\underline{\alpha}^{(s)})$ relies on processing the input vector at multiple samples per symbol ($N_{ss}$). More specifically, this explicit method comprises recreating the distortion by processing the inputs of the predistorter at multiple samples per symbol. By way of example, in a first step, the data symbols of each carrier from the previous stage $\underline{a}_{m,n}^{(s)}$ are processed through an interpolating filter, which models the cascade of the transmitted data pulse and the IMUX filter, denoted as the vector $\underline{a}_m^{(s)}(n; L, N_{ss})$ , using the data symbols contained in $a^{(s)}$, as follows:

$$\underline{a}_m^{(s)}(n; L, N_{SS}) = \left[ a_{m,n-\frac{L-1}{2}}^{(s)} \underline{0}_{N_{ss}-1} \; a_{m,n-\frac{L-1}{2}+1}^{(s)} \underline{0}_{N_{ss}-1} \; \cdots \; a_{m,n+\frac{L-1}{2}}^{(s)} \underline{0}_{N_{ss}-1} \right]^T , \tag{12}$$

where $\underline{0}_K$ reflects the all-zero vector of length $K$, and $L$ reflects the double-sided memory span of the predistorter.

The vector $\underline{a}_m^{(s)}(n; L, N_{SS})$ for each carrier is subsequently processed (as an inner-product) by the vector of filter coefficients $\underline{\dot{p}}_m$, representing the cascade of the transmit filter 107 ($p_{m,T}$) and the IMUX model, and frequency-translated to the respective center frequency of the respective carrier (the $m^{th}$ carrier), as follows:

$$b_{m,n} = \left( \underline{\dot{p}}_m^T \cdot \underline{a}_m^{(s)}(n; L, N_{SS}) \right) \cdot e^{j\left(2\pi f_m \frac{n}{N_{ss}} T_s + \theta_m\right)} , \tag{13}$$

where $n = 0, 1, \ldots, N \cdot N_{ss} - 1$, and $1 \leq m \leq M_c$. Vector can be formed by stacking the samples $b_{m,n}$ of equation (13) for each one of the $M_c$ carriers, as follows:

$$\underline{s}_m = \begin{bmatrix} b_{m,0} & b_{m,1} & \dots & b_{m,NN_{ss}-1} \end{bmatrix}^T . \qquad (14)$$

The value $N_{ss}$ in equation (12) should be large enough to avoid the aliasing effect of IMD when $M_c$ carriers share the same transponder.

The composite vector $\underline{\zeta}$ is then formed and scaled to the correct IBO level of the HPA (TWTA), as follows:

$$\underline{\zeta} = \gamma_{IBO} \cdot \sum_{m=1}^{M_c} \underline{s}_m . \qquad (15)$$

The AM/AM and AM/PM distortions are computed based on the corresponding TWTA conversion model and applied to each of the samples of $\underline{\zeta}$ producing the distorted sample $\tilde{\zeta}_n$ , as follows:

$$\tilde{\zeta}_n = \alpha_{TWTA}(|\zeta_n|) \cdot e^{j\left(\angle \zeta_n + \psi_{TWTA}(|\zeta_n|)\right)} , \qquad (16)$$

where $0 \le n < N \cdot N_{ss}$, and $|\zeta_n|$ and $\angle \zeta_n$ are the amplitude and phase of the input $\zeta_n$, respectively, and $a_{TWTA}(x)$ and $\psi_{TWTA}(x)$ are the amplitude and phase distortion, respectively, of the TWTA model.

Next, the impact of the cascade of the OMUX and receive filters $107_1,..., 107M_c$, (appropriately decimated at the output to one sample per symbol) is replicated (using the samples $\tilde{\zeta}_n$) to form the respective vectors:

$$\underline{\rho}(n; L, N_{ss}) = \begin{bmatrix} \tilde{\zeta}_{n-\frac{L-1}{2}N_{ss}} & \tilde{\zeta}_{n-\frac{L-1}{2}N_{ss}+1} & \dots & \tilde{\zeta}_{n+\frac{L-1}{2}N_{ss}} \end{bmatrix}^T , \qquad (17)$$

which reflects a vector of filter coefficients $\underline{\ddot{p}}_m$, representing the cascade of the receive filter $p_{m,R}$ and the OMUX model. The vector $\rho(n; L, N_{ss})$ is then be processed by the filter $\underline{\ddot{p}}_{md}$ (as an inner-product) and frequency-translated to the desired $m_d{}^{th}$ channel, whose distortion is estimated as follows:

$$u_{m_d,n} = \left( \underline{\ddot{p}}_{m_d}^T \cdot \underline{\rho}(n; L, N_{ss}) \right) \cdot e^{-j\left(2\pi f_{m_d}\frac{n}{N_{ss}}T_s + \theta_{m_d}\right)} . \qquad (18)$$

Further, the vector $\underline{\mathcal{U}}_{m_d}$ is formed by stacking only the samples of $u_{md,n}$ that are spaced by $N_{ss}$ , or:

$$\underline{\mathcal{U}}_{m_d} = \begin{bmatrix} u_{m_d,0} & u_{m_d,N_{ss}} & \dots & u_{m_d,(N-1)N_{ss}} \end{bmatrix}^T . \qquad (19)$$

Finally, the explicit implementation of the distortion is determined as follows:

$$\underline{\mathcal{H}}_{m_d}\left( \underline{\alpha}^{(s)} \right) = \underline{\mathcal{U}}_{m_d} / \gamma_{m_d} , \qquad (20)$$

where $\gamma_{md}$ reflects a complex-valued gain correction configured to remove the effect of the warping caused by the IMD distortion, which is determined as follows:

$$\gamma_{m_d} = \underline{\mathcal{U}}_{m_d}^T \cdot \underline{a}_{m_d}^* . \qquad (21)$$

B. Volterra Approach

According to a second approach, which is not corresponding to the claimed invention, the Volterra method of implementing the distortion estimation $\underline{\mathcal{H}}_{m_d}\left( \underline{\alpha}^{(s)} \right)$ operates on one sample per symbol, and utilizes an analytical characterization of the nonlinear IMD based on a multicarrier Volterra series representation.

By way of example, the distortion estimation $\underline{\mathcal{H}}_{m_d}(\underline{\alpha}^{(s)})$ can be obtained as the output of a 3rd-order Volterra filter, whereby:

$$\underline{\mathcal{H}}_{m_d}(\underline{\alpha}^{(s)}) = H_{m_d}^T \cdot a_{NL}^{(s)(3)}, \tag{22}$$

where $H_{md} = [\underline{h}_{md}(0)\ \underline{h}_{md}(1)\ ...\ \underline{h}_{md}(N-1)]$ and

$$a_{NL}^{(s)(3)} = \left[\underline{a}_{NL}^{(s)(3)}(0)\ \underline{a}_{NL}^{(s)(3)}(1)\ ...\ \underline{a}_{NL}^{(s)(3)}(N-1)\right].$$

The vector $\underline{h}_{md}(n)$ models the 1st-order and 3rd-order IMD terms in the Volterra filter, whereby:

$$\underline{h}_{m_d}(n) \triangleq \begin{bmatrix} \underline{h}_{m_d}^{(1)}(n;\ L^{(1)}) \\ \underline{h}_{m_d}^{(3)}(n;\ L^{(3)}) \end{bmatrix} ;\ m_d = 1, 2, ..., M_c, \tag{23}$$

where

$$\underline{h}_{m_d}^{(1)}(n;\ L^{(1)}) \triangleq \begin{bmatrix} \underline{\eta}_{1m_d}^{(1)}(n;\ L^{(1)}) \\ \vdots \\ \underline{\eta}_{M_c m_d}^{(1)}(n;\ L^{(1)}) \end{bmatrix}, \tag{24}$$

and

$$\underline{h}_{m_d}^{(3)}(n;\ L^{(3)}) \triangleq \begin{bmatrix} \underline{\eta}_{m_1 m_2 m_3 m_d}^{(3)}(n;\ L^{(3)}) \\ \vdots \\ \underline{\eta}_{\acute{m}_1 \acute{m}_2 \acute{m}_3 m_d}^{(3)}(n;\ L^{(3)}) \end{bmatrix}, \tag{25}$$

The vectors $\underline{h}_{m_d}^{(1)}(n;\ L^{(1)})$ and $\underline{h}_{m_d}^{(3)}(n;\ L^{(3)})$ of (24)-(25) in turn comprise vectors $\underline{\eta}_{m m_d}^{(1)}(n;\ L^{(1)})$ and $\underline{\eta}_{m_1 m_2 m_3 m_d}^{(3)}(n;\ L^{(3)})$, which incorporate the memory of the 1st-order interference from the $m^{th}$ carrier, of size $L^{(1)}$ symbols, and the memory of the 3rd-order interference, of size $L^{(3)}$ symbols, associated with carrier combination $[m_1 m_2 m_3]$, respectively, as follows:

$$\underline{\eta}_{m m_d}^{(1)}(n;\ L^{(1)}) \triangleq e^{j\left(2\pi\left(f_m - f_{m_d}\right)nT_s + \left(\theta_m - \theta_{m_d}\right)\right)}.$$

$$\begin{bmatrix} h^{(1)}_{mm_d}\left(\left(\frac{L^{(1)}-1}{2}\right)T_s; f_m - f_{m_d}\right) \\ h^{(1)}_{mm_d}\left(\left(\frac{L^{(1)}-1}{2}-1\right)T_s; f_m - f_{m_d}\right) \\ \vdots \\ h^{(1)}_{mm_d}\left(\left(-\frac{L^{(1)}-1}{2}\right)T_s; f_m - f_{m_d}\right) \end{bmatrix} \qquad (26)$$

and

$$\underline{\eta}^{(3)}_{m_1 m_2 m_3 m_d}\left(n;\ L^{(3)}\right) \triangleq 2^{1-\delta_{m_1 m_2}} \cdot e^{j\left(2\pi\left(f_{m_1}+f_{m_2}-f_{m_3}-f_{m_d}\right)nT_s+\left(\theta_{m_1}+\theta_{m_2}-\theta_{m_3}-\theta_{m_d}\right)\right)}.$$

$$\begin{bmatrix} h^{(3)}_{m_1 m_2 m_3 m_d}\left(\frac{L^{(3)}-1}{2}T_s, \frac{L^{(3)}-1}{2}T_s, \frac{L^{(3)}-1}{2}T_s;\ f_{m_1}+f_{m_2}-f_{m_3}-f_{m_d}\right) \\ h^{(3)}_{m_1 m_2 m_3 m_d}\left(\frac{L^{(3)}-1}{2}T_s, \frac{L^{(3)}-1}{2}T_s, \left(\frac{L^{(3)}-1}{2}-1\right)T_s;\ f_{m_1}+f_{m_2}-f_{m_3}-f_{m_d}\right) \\ \vdots \\ h^{(3)}_{m_1 m_2 m_3 m_d}\left(-\frac{L^{(3)}-1}{2}T_s, -\frac{L^{(3)}-1}{2}T_s, -\frac{L^{(3)}-1}{2}T_s;\ f_{m_1}+f_{m_2}-f_{m_3}-f_{m_d}\right) \end{bmatrix} \qquad (27)$$

where $h^{(1)}_{mm_d}(t; f)$ and $h^{(3)}_{m_1 m_2 m_3 m_d}(t_1, t_2, t_3; f)$ reflect the generalized Volterra kernels of the 1st-order and 3rd-order.

The corresponding vector of symbols in equation (22) can be denoted as follows:

$$\underline{a}^{(s)(3)}_{NL}(n) \triangleq \begin{bmatrix} \underline{a}^{(s)(1)}\left(n;\ L^{(1)}\right) \\ \underline{a}^{(s)(3)}\left(n;\ L^{(3)}\right) \end{bmatrix}, \qquad (28)$$

where

$$\underline{a}^{(s)(1)}\left(n;\ L^{(1)}\right) \triangleq \begin{bmatrix} \underline{a}^{(s)(1)}_1\left(n;\ L^{(1)}\right) \\ \vdots \\ \underline{a}^{(s)(1)}_{M_c}\left(n;\ L^{(1)}\right) \end{bmatrix}, \qquad (29)$$

and

$$\underline{a}^{(s)(3)}\left(n;\ L^{(3)}\right) \triangleq \begin{bmatrix} \underline{a}^{(s)(3)}_{m_1 m_2 m_3}\left(n;\ L^{(3)}\right) \\ \vdots \\ \underline{a}^{(s)(3)}_{\acute{m}_1 \acute{m}_2 \acute{m}_3}\left(n;\ L^{(3)}\right) \end{bmatrix}. \qquad (30)$$

In equations (29)-(30), $\underline{a}_m^{(s)(1)}\left(n;\ L^{(1)}\right)$ reflects the vector of interfering symbols of the 1st-order from the $m^{th}$ carrier, with double-sided memory of $L^{(1)}$ symbols, as follows:

$$\underline{a}_m^{(s)(1)}\left(n;\ L^{(1)}\right) \triangleq \begin{bmatrix} a^{(s)}_{m,n-\frac{L^{(1)}-1}{2}} \\ a^{(s)}_{m,n-\frac{L^{(1)}-1}{2}+1} \\ \vdots \\ a^{(s)}_{m,n+\frac{L^{(1)}-1}{2}} \end{bmatrix}, \tag{31}$$

and $\underline{a}_{m_1 m_2 m_3}^{(s)(3)}\left(n;\ L^{(3)}\right)$ reflects the vector of interfering symbols of the 3rd-order associated with the $[m_1 m_2 m_3]$ carrier combination and double-sided memory of $L^{(3)}$ symbols, as follows:

$$\underline{a}_{m_1 m_2 m_3}^{(s)(3)}\left(n;\ L^{(3)}\right) \triangleq \begin{bmatrix} a^{(s)}_{m_1,n-\frac{L^{(3)}-1}{2}} \cdot a^{(s)}_{m_2,n-\frac{L^{(3)}-1}{2}} \cdot a^{(s)*}_{m_3,n-\frac{L^{(3)}-1}{2}} \\ a^{(s)}_{m_1,n-\frac{L^{(3)}-1}{2}} \cdot a^{(s)}_{m_2,n-\frac{L^{(3)}-1}{2}} \cdot a^{(s)*}_{m_3,n-\frac{L^{(3)}-1}{2}+1} \\ \vdots \\ a^{(s)}_{m_1,n+\frac{L^{(3)}-1}{2}} \cdot a^{(s)}_{m_2,n+\frac{L^{(3)}-1}{2}} \cdot a^{(s)*}_{m_3,n+\frac{L^{(3)}-1}{2}} \end{bmatrix}. \tag{32}$$

In the Volterra-based approach, the filter coefficients $h^{(1)}_{m m_d}$ and $h^{(3)}_{m_1 m_2 m_3 m_d}$ are known to or preconfigured in the predistorter. Further details of such Volterra filter based estimations are described in the article B. F. Beidas, "Intermodulation distortion in multicarrier satellite systems: Analysis and turbo volterra equalization," IEEE Trans. Comm., vol. 59, no. 6, pp. 1580-1590, June 2011. Further, by way of example, the filter coefficients may be adaptively determined using a recursive least squares (RLS) filter algorithm, which would facilitate a rapid response to any variation in the operating environment (such as the amplifier back-off level) without *a priori* knowledge of the nonlinear channel characteristics. Such an approach is advocated in the article: B. F. Beidas and R. I. Seshadri, "Analysis and compensation for nonlinear interference of two high-order modulation carriers over satellite link," IEEE Trans. Comm., vol. 58, no. 6, pp. 1824-1833, June 2010). Also, the text S. Haykin, Adaptive Filter Theory, 2nd ed. Englewood Cliffs, NJ: Prentice-Hall, 1991 provides a description of such an RLS filter algorithm. By way of further example, one possible realization of the adaptation may comprise a training phase, during which the transmitter or gateway sends known/training sequences $\underline{a}_{(m,train)}$; $m = 1, 2,...,M_c$, simultaneously on all $M_c$ carriers. The corresponding $M_c$ receivers independently demodulate the respective in-band received signal to generate $x_{m,train}(nT_s)$; $m = 1, 2,...,M_c$. The demodulated sequence could then be fed back to the gateway, which may then perform the RLS adaptation, formulated to minimize the least-squares value of the error, as follows:

$$\varepsilon_m^{(LS)}(n) = \sum_{i=1}^{n} \lambda^{n-i} \cdot \left| x_{m,train}(i) - \underline{h}_m^T(n) \cdot \underline{a}_{NL,train}^{(s)(3)}(i) \right|^2 ; m = 1, 2, ..., M_c , \tag{33}$$

where the parameter $\lambda$ reflects the forgetting factor; $0 < \lambda \leq 1$. By way of further example, the desired value of the filter coefficient vector can be computed in a recursive manner with the following set of expressions:

$$k(n) = \frac{\lambda^{-1} \cdot P(n-1) \cdot \underline{a}_{NL,train}^{(s)(3)}(i)}{1 + \lambda^{-1} \cdot \left(\underline{a}_{NL,train}^{(s)(3)}(i)\right)^H \cdot P(n-1) \cdot \underline{a}_{NL,train}^{(s)(3)}(i)} \qquad (34)$$

$$\alpha(n) = x_{m,train}(n) - \underline{h}_m^T(n-1) \cdot \underline{a}_{NL,train}^{(s)(3)}(n) \qquad (35)$$

$$\underline{h}_m(n) = \underline{h}_m(n-1) + \underline{k}(n) * \alpha^*(n) \qquad (36)$$

$$P(n) = \lambda^{-1} \cdot P(n-1) - \lambda^{-1} \cdot \underline{k}(n) \cdot \left(\underline{a}_{NL,train}^{(s)(3)}(i)\right)^H \cdot P(n-1) \qquad (37)$$

Further, the receivers participating in the training need only be specialized in the sense of having the capability to provide feedback to the gateway. More specifically, the receivers may be single-carrier receivers that demodulate their own data only and do not require tuning to the other $M_c$ - 1 carrier frequencies involved in the multicarrier predistortion. Further, this process of estimation can be done offline, using dedicated servers afforded at the gateway, whenever a change in the input backoff level of the TWTA needs adjustment. It can also be repeated at a slow rate to track long-term variations in the transponder characteristics.

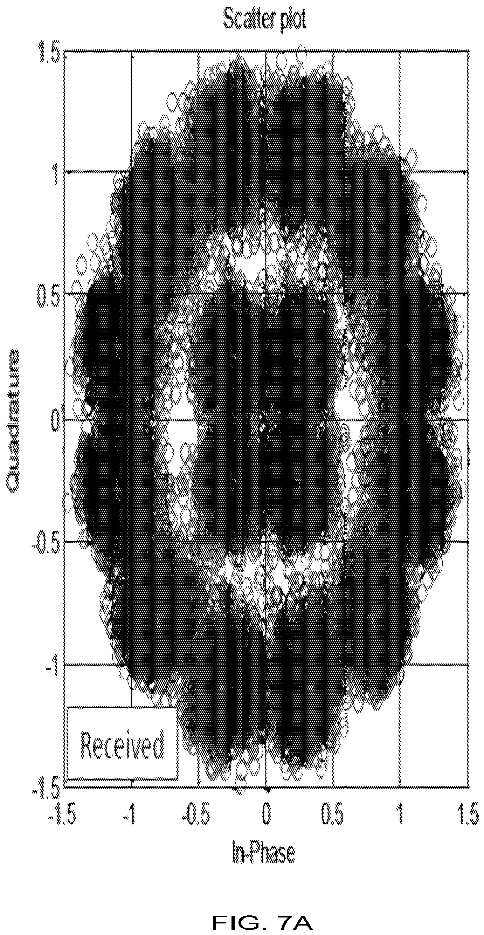

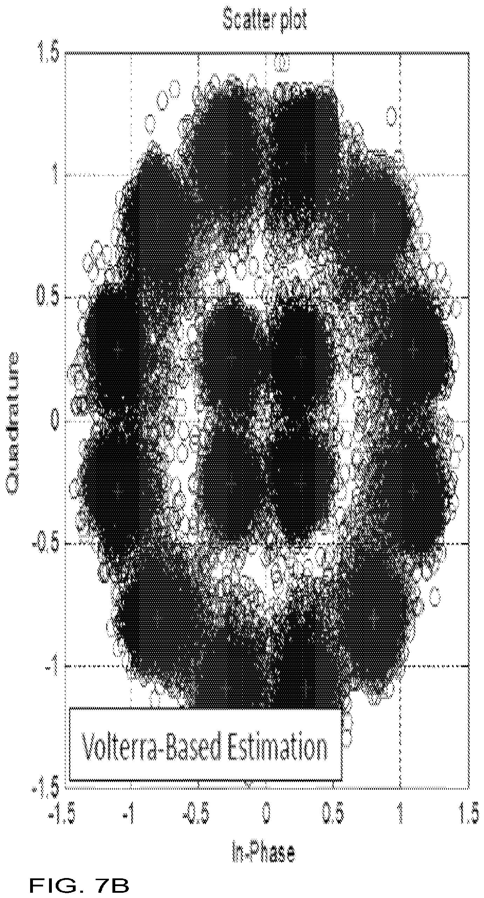

Further, in providing the distortion estimate $\mathcal{H}_{m_d}\left(\underline{\alpha}^{(s)}\right)$ needed for the multicarrier PD, the accuracy of the Volterra-based implementation can be demonstrated as follows. For example, the multicarrier system model shown in FIG. 3 can be used with $M_c = 4$, $\Delta f = 40$MHz, $R_s = 37$Mbaud and root-raised cosine (RRC) filters of rolloff = 0.1. The IMUX/OMUX filter responses and TWTA characteristics are as shown in FIGs. 5A-5F. FIGs. 7A and 7B illustrate noiseless scattered diagrams comparing the desired received signal versus its reconstruction using the Volterra-based method. The scatter-plots are as measured at the output of the Volterra filter, shown for the second carrier in the four-carrier composite, in the absence of AWGN, but including the IMD seen at that carrier receiver. The Volterra filter incorporates nonlinear terms up to the 3rd-order, with its coefficients computed using the adaptation technique described above. The plots confirm that the Volterra filter can perform excellent reconstruction of the nonlinear distortion, yielding an mean-squared-error (MSE) close to -32dB between the desired received signal and its reconstructed version.

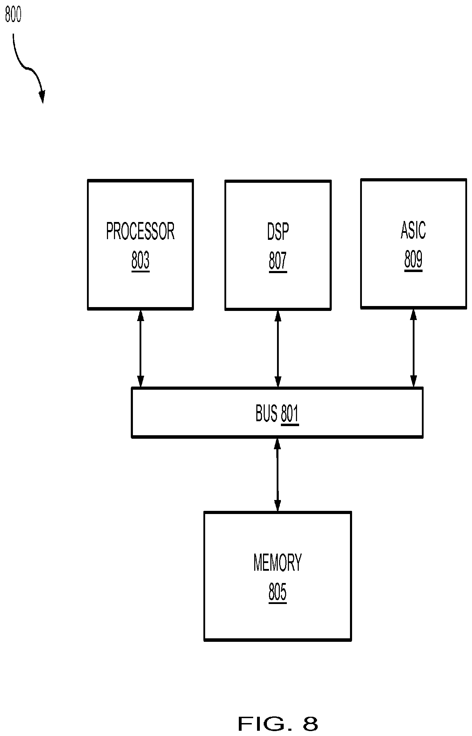

FIG. 8 illustrates a block diagram of a chip set that can be utilized in implementing example embodiments according to the present invention. Chip set 800 includes, for instance, processor and memory components described with respect to FIG. 8 incorporated in one or more physical packages. By way of example, a physical package includes an arrangement of one or more materials, components, and/or wires on a structural assembly (e.g., a baseboard or printed circuit board) to provide one or more characteristics such as physical strength, conservation of size, and/or limitation of electrical interaction.

In one embodiment, the chip set 800 includes a communication mechanism such as a bus 801 for passing information among the components of the chip set 800. A processor 803 has connectivity to the bus 801 to execute instructions/programs and process information stored in, for example, a memory 805. The processor 803 may include one or more processing cores with each core configured to perform independently. A multi-core processor enables multiprocessing within a single physical package, such as two, four, eight, or greater numbers of processing cores. Alternatively or in addition, the processor 803 may include one or more microprocessors configured in tandem via the bus 801 to enable independent execution of instructions, pipelining, and multithreading. The processor 803 may also be accompanied with one or more specialized components to perform certain processing functions and tasks such as one or more digital signal processors (DSP) 807, and/or one or more application-specific integrated circuits (ASIC) 809. A DSP 807 typically is configured to process real-time signals (e.g., sound or video) in real time independently of the processor 803. Similarly, an ASIC 809 can be configured to performed specialized functions not easily performed by a general purpose processor. Other specialized components to aid in performing the inventive functions described herein may include one or more field programmable gate arrays (FPGA) (not shown), one or more controllers (not shown), or one or more other special-purpose computer chips.

The processor 803 and accompanying components have connectivity to the memory 805 via the bus 801. The memory 805 may include both dynamic memory (e.g., RAM) and static memory (e.g., ROM) for storing executable instructions that, when executed by the processor 803 and/or the DSP 807 and/or the ASIC 809, perform the process of example embodiments as described herein. The memory 805 may also store the data associated with or generated by the execution of the process.

Further, the functionality of the example embodiments of the present invention may be provided by the chip set 800, in response to the processor 803 executing an arrangement of program instructions contained in memory 805. Execution of the program instructions contained in memory 805 causes the processor 803 to perform the process steps and generate the results described herein. One or more processors in a multi-processing arrangement can also be employed to execute the program instructions. In alternative embodiments, hard-wired circuitry can be used in place of or in combination with software instructions to implement the example embodiments. Thus, embodiments of the present invention are not limited to any specific combination of hardware circuitry and software.

While example embodiments of the present invention may provide for various implementations (e.g., including hardware, firmware and/or software components), and, unless stated otherwise, all functions are performed by a CPU or a processor executing computer executable program code stored in a non-transitory memory or computer-readable storage medium, the various components can be implemented in different configurations of hardware, firmware, software, and/or a combination thereof. Except as otherwise disclosed herein, the various components shown in outline or in block form in the figures are individually well known and their internal construction and operation are not critical either to the making or using of this invention or to a description of the best mode thereof.

In the preceding specification, various embodiments have been described with reference to the accompanying drawings. It will, however, be evident that various modifications may be made thereto, and additional embodiments may be implemented, without departing from the broader scope of the invention as set forth in the claims that follow. The specification and drawings are accordingly to be regarded in an illustrative rather than restrictive sense.

**Claims**

1. A method comprising:

receiving a plurality of source signals, wherein each source signal comprises a sequence of source data symbols;
encoding and modulating each source signal for transmission via a multicarrier channel (114) of a wireless communications system (130);
generating a final predistorted version for each encoded and modulated source signal;
applying a transmit filter (107) to the final predistorted version of each of the source signals;
translating each of the filtered signals to a respective carrier frequency; and
combining the translated signals to generate a composite signal for transmission via the multicarrier channel (114);
wherein the final predistorted version for each of the encoded and modulated source signals is generated via an iterative process of a number of stages, wherein, for a given stage and for each source signal, the process comprises:

receiving a respective prior predistorted version of each of the source signals from a preceding stage; and
processing the prior predistorted version of the source signal configured by the received prior predistorted versions of all of the source signals from the preceding stage,
wherein for each source signal and for the given stage s of the iterative process for the generation of the final predistorted version for each of the encoded and modulated source signals:
the predistorted version of each of the source signals from the preceding stage is represented as a vector of data symbols $\underline{a}^{(s)}$ associated with the respective carrier frequency;
a further predistorted version of the source signal is generated by modifying the vector of data symbols $\underline{a}^{(s)}$, representing the predistorted version of the source signal from the preceding stage, configured by a correction term, wherein the correction term is proportional to an error vector $\underline{e}_{m_d}^{(s)}$, representing an estimated predistortion configured by a distortion estimate that is performed by an estimation of the intermodulation distortion effects of all adjacent carriers sharing the multicarrier channel (114);
wherein the distortion estimation comprises:

processing data symbols of each carrier from the previous stage $\underline{a}_{m,n}^{(s)}$ through an interpolating filter, which models the cascade of the transmitted data pulse and the input multiplexing, IMUX, filter, denoted as the vector $\underline{a}_m^{(s)}(n; L, N_{ss})$, using the data symbols contained in $\underline{a}^{(s)}$, by

$$\underline{a}_m^{(s)}(n;L,N_{ss}) = \left[ a_{m,n-\frac{L-1}{2}}^{(s)} \quad \underline{0}_{N_{ss}-1} \quad a_{m,n-\frac{L-1}{2}+1}^{(s)} \quad \underline{0}_{N_{ss}-1} \quad \cdots \quad a_{m,n+\frac{L-1}{2}}^{(s)} \quad \underline{0}_{N_{ss}-1} \right]^T,$$

wherein $N_{ss}$ reflects the input vector at multiple samples per symbol, $\underline{0}_K$ reflects the all-zero vector of length $K$, and $L$ reflects the double-sided memory span of the predistorter,

processing the vector $\underline{a}_m^{(s)}(n;L,N_{ss})$ for each carrier by a vector of filter coefficients $\dot{\underline{p}}_m$, representing the cascade of the transmit filter (107) and the IMUX model, and frequency-translated to the respective center frequency of the respective carrier, the $m^{th}$ carrier, by:

$$b_{m,n} = \left( \dot{\underline{p}}_m^T \cdot \underline{a}_m^{(s)}(n;L,N_{ss}) \right) \cdot e^{j\left(2\pi f_m \frac{n}{N_{ss}} T_s + \theta_m\right)},$$

forming a vector by stacking the samples $b_{m,n}$ for each one of the $M_c$ carriers, by:

$$\underline{S}_m = \left[ b_{m,0} \quad b_{m,1} \cdots \quad b_{m,NN_{ss}-1} \right]^T,$$

forming and scaling a composite vector $\underline{\zeta}$ to a correct input backoff level, IOB, of the high power amplifier (121), HPA, by:

$$\underline{\zeta} = \gamma_{IBO} \cdot \sum_{m=1}^{M_c} \underline{S}_m,$$

computing an AM/AM and AM/PM distortions configured by a corresponding HPA conversion model and applied to each of the samples of $\underline{\zeta}$ producing the distorted sample $\tilde{\zeta}_n$, by:

$$\tilde{\zeta}_n = \alpha_{TWTA}(|\zeta_n|) \cdot e^{j\left(\angle\zeta_n + \psi_{TWTA}(|\zeta_n|)\right)},$$

wherein $0 \le n < N \cdot N_{ss}$, and $|\zeta_n|$ and $\angle\zeta_n$ are the amplitude and phase of the input $\zeta_n$, respectively, and $a_{TWTA}(x)$ and $\psi_{TWTA}(x)$ are the amplitude and phase distortion, respectively, of the HPA model, replicating the impact of a cascade of output multiplexing, OMUX, and receive filters ($107_1$, ..., $107_{Mc}$) to form the respective vectors:

$$\underline{\rho}(n;L,N_{ss}) = \left[ \tilde{\zeta}_{n-\frac{L-1}{2}N_{ss}} \quad \tilde{\zeta}_{n-\frac{L-1}{2}N_{ss}+1} \quad \cdots \quad \tilde{\zeta}_{n+\frac{L-1}{2}N_{ss}} \right]^T,$$

which reflects a vector of filter coefficients $\ddot{\underline{p}}_m$, representing the cascade of the receive filter $p_{m,R}$ and the OMUX model,
processing the vector $\rho(n;L,N_{ss})$ by the filter $\ddot{\underline{p}}_{md}$ and frequency-translated to the desired $m_d^{th}$ channel, whose distortion is estimated by:

$$u_{m_d,n} = \left( \ddot{\underline{p}}_{m_d}^T \cdot \underline{\rho}(n;L,N_{ss}) \right) \cdot e^{-j\left(2\pi f_{m_d} \frac{n}{N_{ss}} T_s + \theta_{m_d}\right)},$$

forming the vector $\underline{u}_{m_d}$ by stacking only the samples of $u_{md,n}$ that are spaced by $N_{ss}$, by

$$\underline{u}_{m_d} = \left[ u_{m_d,0} \quad u_{m_d,N_{ss}} \cdots \quad u_{m_d,(N-1)N_{ss}} \right]^T,$$

wherein the intermodulation distortion is determined by: $\underline{\mathcal{H}}_{m_d}\left(\underline{\alpha}^{(s)}\right) = \underline{\mathcal{U}}_{m_d}/\gamma_{m_d}$ , wherein $\gamma_{md}$ reflects a complex-valued gain correction configured to remove the effect of the warping caused by the IMD distortion, which is determined by:

$$\gamma_{m_d} = \underline{\mathcal{U}}_{m_d}^{T} \cdot \underline{a}_{m_d}^{*};$$

and wherein the further predistorted versions of all of the source signals are fed-back for processing via the next stage.

2. The method according to claim 1, wherein the processing of the prior predistorted version of the source signal configured by the received prior predistorted versions of all the encoded and modulated source signals from the preceding stage comprises generating an error signal configured by the distortion estimate.

3. The method according to claim 2, wherein the error signal is driven towards zero by applying the estimation via the iterative process.

4. The method according to claim 1, wherein the distortion estimate is represented as a vector configured by a vector representation of the further predistorted versions for each of the source signals, and the distortion estimate is used to generate an error vector for the source signal relative to an undistorted version of the encoded and modulated source signal.

5. The method according to claim 4, wherein the error vector for the source signal is generated by subtracting the distortion estimate vector from the undistorted version of the encoded and modulated source signal.

6. The method according to claim 5, wherein the error vector for the source signal is driven towards zero by the iterative predistortion process.

7. The method according to claim 1, wherein the modification of the vector of data symbols, representing the predistorted version of the source signal from the preceding stage, configured by the correction term comprises:

   processing the error vector, representing the estimated predistortion configured by the distortion estimate that would result from passing the composite signal through the multicarrier channel, configured by a step-size sequence to generate a modified error vector; and
   adding the modified error vector to the vector of data symbols, representing the predistorted version of the source signal from the preceding stage, to generate the further predistorted version of the source signal.

8. The method according to claim 7, wherein the step size sequence is defined to be positive and decreasing to drive the error vector towards zero.

9. The method according to claim 7, wherein the step-size sequence serves to optimize performance of the predistortion process by maximizing convergence speed, reduction of the number of predistorter stages, while minimizing residual error.

10. A transmitter apparatus comprising:

   a receiver interface configured to receive a plurality of source signals, wherein each source signal comprises a sequence of source data symbols;
   an encoder ($101_1...101_{MC}$) and a modulator ($103_1...103_{MC}$) configured to encode and modulate each source signal for transmission via a multicarrier channel (114) of a wireless communications system (130);
   a processor configured to generate a final predistorted version for each encoded and modulated source signal;
   a transmit filter configured to filter to the final predistorted version of each of the source signals;
   a signal processor (803) configured to translate each of the filtered signals to a respective carrier frequency; and
   a signal combiner configured to combine the translated signals to generate a composite signal for transmission via the multicarrier channel (114);
   wherein the processor (803) is configured to generate the final predistorted version for each encoded and modulated source signal via an iterative process of a number of stages s, wherein, for a given stage and for each source signal, the process comprises:

receiving a respective prior predistorted version of each of the source signals from a preceding stage; and processing the prior predistorted version of the source signal configured by the received prior predistorted versions of all of the source signals from the preceding stage,

wherein for each source signal and for the given stage of the iterative process for the generation of the final predistorted version for each of the encoded and modulated source signals:

the predistorted version of each of the source signals from the preceding stage is represented as a vector of data symbols $\underline{a}^{(s)}$ associated with the respective carrier frequency;

a further predistorted version of the source signal is generated by modifying the vector of data symbols $\underline{a}^{(s)}$, representing the predistorted version of the source signal from the preceding stage, configured by a correction term, wherein the correction term is proportional to an error vector $\underline{e}_{m,d}^{(s)}$, representing an estimated predistortion configured by a distortion estimate that is performed by an estimation of the intermodulation distortion effects of all adjacent carriers sharing the multicarrier channel;

wherein the distortion estimation comprises:

processing data symbols of each carrier from the previous stage $\underline{a}_{m,n}^{(s)}$ through an interpolating filter, which models the cascade of the transmitted data pulse and the input multiplexing, IMUX, filter, denoted as the vector $\underline{a}_m^{(s)}(n; L, N_{SS})$, using the data symbols contained in $\underline{a}^{(s)}$, by

$$\underline{a}_m^{(s)}(n; L, N_{SS}) = \left[ a_{m,n-\frac{L-1}{2}}^{(s)} \quad \underline{0}_{N_{SS}-1} \quad a_{m,n-\frac{L-1}{2}+1}^{(s)} \quad \underline{0}_{N_{SS}-1} \quad \cdots \quad a_{m,n+\frac{L-1}{2}}^{(s)} \quad \underline{0}_{N_{SS}-1} \right]^T,$$

wherein $N_{ss}$ reflects the input vector at multiple samples per symbol, $\underline{0}_K$ reflects the all-zero vector of length $K$, and $L$ reflects the double-sided memory span of the predistorter,

processing a vector $\underline{a}_m^{(s)}(n; L, N_{ss})$ for each carrier by a vector of filter coefficients $\dot{\underline{p}}_m$, representing the cascade of the transmit filter (107) and the IMUX model, and frequency-translated to the respective center frequency of the respective carrier, the $m^{th}$ carrier, by:

$$b_{m,n} = \left( \dot{\underline{p}}_m^T \cdot \underline{a}_m^{(s)}(n; L, N_{ss}) \right) \cdot e^{j\left(2\pi f_m \frac{n}{N_{ss}} T_s + \theta_m\right)},$$

forming a vector by stacking the samples $b_{m,n}$ for each one of the $M_c$ carriers, by:

$$\underline{S}_m = \left[ b_{m,0} \quad b_{m,1} \cdots \quad b_{m,NN_{ss}-1} \right]^T,$$

forming and scaling a composite vector $\underline{\zeta}$ to a correct input backoff level, IOB, of the high power amplifier (121), HPA, by:

$$\underline{\zeta} = \gamma_{IBO} \cdot \sum_{m=1}^{M_c} \underline{S}_m,$$

computing an AM/AM and AM/PM distortions configured by a corresponding HPA conversion model and applied to each of the samples of $\underline{\zeta}$ producing the distorted sample $\tilde{\zeta}_n$, by:

$$\tilde{\zeta}_n = \alpha_{TWTA}(|\zeta_n|) \cdot e^{j\left(\angle \zeta_n + \psi_{TWTA}(|\zeta_n|)\right)},$$

wherein $0 \leq n < N \cdot N_{ss}$, and $|\zeta_n|$ and $\angle \zeta_n$ are the amplitude and phase of the input $\zeta_n$, respectively, and

$a_{TWTA}(x)$ and $\psi_{TWTA}(x)$ are the amplitude and phase distortion, respectively, of the HPA model, replicating the impact of a cascade of output multiplexing, OMUX, and receive filters ($107_1$, ..., $107_{Mc}$) to form the respective vectors:

$$\underline{\rho}(n; L, N_{ss}) = \begin{bmatrix} \tilde{\zeta}_{n-\frac{L-1}{2}N_{ss}} & \tilde{\zeta}_{n-\frac{L-1}{2}N_{ss}+1} & \cdots & \tilde{\zeta}_{n+\frac{L-1}{2}N_{ss}} \end{bmatrix}^T,$$

which reflects a vector of filter coefficients $\ddot{\underline{p}}_m$, representing the cascade of the receive filter $p_{m,R}$ and the OMUX model,

processing the vector $\underline{\rho}(n; L, N_{ss})$ by the filter $\ddot{\underline{p}}_{md}$ and frequency-translated to the desired $m_d^{th}$ channel, whose distortion is estimated by:

$$u_{m_d,n} = \left( \ddot{\underline{p}}_{m_d}^T \cdot \underline{\rho}(n; L, N_{ss}) \right) \cdot e^{-j\left(2\pi f_{m_d}\frac{n}{N_{ss}}T_s + \theta_{m_d}\right)},$$

forming the vector $\underline{\mathcal{U}}_{m_d}$ by stacking only the samples of $u_{md,n}$ that are spaced by $N_{ss}$, by

$$\underline{\mathcal{U}}_{m_d} = \begin{bmatrix} u_{m_d,0} & u_{m_d,N_{ss}} & \cdots & u_{m_d,(N-1)N_{ss}} \end{bmatrix}^T,$$

wherein the intermodulation distortion is determined by: $\underline{\mathcal{H}}_{m_d}\left(\underline{\alpha}^{(s)}\right) = \underline{\mathcal{U}}_{m_d}/\gamma_{m_d}$, wherein $\gamma_{md}$ reflects a complex-valued gain correction configured to remove the effect of the warping caused by the IMD distortion, which is determined by:

$$\gamma_{m_d} = \underline{\mathcal{U}}_{m_d}^T \cdot \underline{a}_{m_d}^*;$$

and wherein the further predistorted versions of all of the source signals are fed-back for processing via the next stage.

11. The apparatus according to claim 10, wherein the processing of the prior predistorted version of the source signal configured by the received prior predistorted versions of all the encoded and modulated source signals from the preceding stage comprises generating an error signal configured by the distortion estimate.

12. The apparatus according to claim 11, wherein the error signal is driven towards zero by applying the estimation via the iterative process.

13. The apparatus according to claim 10, wherein the distortion estimate is represented as a vector configured by a vector representation of the further predistorted versions for each of the source signals, and the distortion estimate is used to generate an error vector for the source signal relative to an undistorted version of the encoded and modulated source signal.

14. The apparatus according to claim 13, wherein the error vector for the source signal is generated by subtracting the distortion estimate vector from the undistorted version of the encoded and modulated source signal.

15. The apparatus according to claim 14, wherein the error vector for the source signal is driven towards zero by the iterative predistortion process.

16. The apparatus according to claim 10, wherein the modification of the vector of data symbols, representing the predistorted version of the source signal from the preceding stage, configured by the correction term comprises:

processing the error vector, representing the estimated predistortion configured by the distortion estimate that would result from passing the composite signal through the multicarrier channel, configured by a step-size sequence to generate a modified error vector; and
adding the modified error vector to the vector of data symbols, representing the predistorted version of the source signal from the preceding stage, to generate the further predistorted version of the source signal.

17. The apparatus according to claim 16, wherein the step size sequence is defined to be positive and decreasing to drive the error vector towards zero.

18. The apparatus according to claim 16, wherein the step-size sequence serves to optimize performance of the predistortion process by maximizing convergence speed, reduction of the number of predistorter stages, while minimizing residual error.

**Patentansprüche**

1. Verfahren mit den Schritten:

Empfangen einer Vielzahl von Quellensignalen, wobei jedes Quellensignal eine Folge von Quellendatensymbolen aufweist;
Codieren und Modulieren jedes Quellensignals zur Übertragung über einen Mehrträgerkanal (114) eines drahtlosen Kommunikationssystems (130);
Erzeugen einer endgültigen vorverzerrten Version für jedes codierte und modulierte Quellensignal;
Anwenden eines Übertragungsfilters (107) auf die endgültige vorverzerrte Version jedes der Quellensignale;
Umsetzen jedes der gefilterten Signale auf eine entsprechende Trägerfrequenz; und
Kombinieren der umgesetzten Signale zur Erzeugung eines zusammengesetzten Signals zur Übertragung über den Mehrträgerkanal (114);
wobei die endgültige vorverzerrte Version für jedes der codierten und modulierten Quellensignale über einen iterativen Prozess aus einer Anzahl von Stufen erzeugt wird, wobei der Prozess für eine vorgegebene Stufe und für jedes Quellensignal folgendes aufweist:

Empfangen einer entsprechenden, zuvor vorverzerrten Version von jedem der Quellensignale aus einer vorhergehenden Stufe; und
Verarbeiten der zuvor vorverzerrten Version des Quellensignals, das durch die empfangenen, zuvor vorverzerrten Versionen aller Quellensignale aus der vorhergehenden Stufe konfiguriert ist,
wobei für jedes Quellensignal und für die vorgegebene Stufe s des iterativen Prozesses zur Erzeugung der endgültigen vorverzerrten Version für jedes der codierten und modulierten Quellensignale:
die vorverzerrte Version jedes der Quellensignale aus der vorhergehenden Stufe als ein Vektor von Datensymbolen $\underline{a}^{(s)}$ dargestellt ist, der der entsprechenden Trägerfrequenz zugeordnet ist;
eine weitere vorverzerrte Version des Quellensignals erzeugt wird, indem der Vektor von Datensymbolen $\underline{a}^{(s)}$, der die vorverzerrte Version des Quellensignals aus der vorhergehenden Stufe darstellt, durch einen Korrekturterm konfiguriert modifiziert wird, wobei der Korrekturterm proportional zu einem Fehlervektor $\underline{e}_{m_d}^{(s)}$ ist, der eine geschätzte Vorverzerrung darstellt, die durch eine Verzerrungsabschätzung konfiguriert ist, welche durch eine Schätzung der Intermodulationsverzerrungseffekte aller benachbarten Träger, die sich den Mehrträgerkanal (114) teilen, durchgeführt wird;
wobei die Verzerrungsschätzung folgendes aufweist:

Verarbeiten von Datensymbolen jedes Trägers aus der vorhergehenden Stufe $\underline{a}_{m,n}^{(s)}$ durch ein Interpolationsfilter, das die Kaskade des übertragenen Datenimpulses und
des Eingangsmultiplexfilters, IMUX, modelliert, bezeichnet als Vektor $\underline{a}_m^{(s)}(n; L, N_{ss})$, unter Verwendung der in $\underline{a}^{(s)}$ enthaltenen Datensymbole, durch

$$\underline{a}_m^{(s)}(n; L, N_{ss}) = \left[ a_{m,n-\frac{L-1}{2}}^{(s)} \ \underline{0}_{N_{ss}-1} \ a_{m,n-\frac{L-1}{2}+1}^{(s)} \ \underline{0}_{N_{ss}-1} \ \cdots \ a_{m,n+\frac{L-1}{2}}^{(s)} \ \underline{0}_{N_{ss}-1} \right]^T,$$

wobei $N_{ss}$ den Eingangsvektor an Mehrfachsamples pro Symbol wiedergibt, $\underline{0}_K$ den Alles-Null-Vektor der Länge $K$ wiedergibt, und $L$ die beidseitige Speicherspanne des Vorverzerrers wiedergibt,

Verarbeiten des Vektors $\underline{a}_m^{(s)}(n; L, N_{ss})$ für jeden Träger durch einen Vektor von Filterkoeffizienten $\dot{p}_m$, der die Kaskade des Übertragungsfilters (107) und des IMUX-Modells darstellt und auf die entsprechende Mittelfrequenz des entsprechenden Trägers, des $m^{ten}$ Trägers, frequenzumgesetzt ist, durch:

$$b_{m,n} = \left(\underline{\dot{p}}_m^T \cdot \underline{a}_m^{(s)}(n; L, N_{ss})\right) \cdot e^{j\left(2\pi f_m \frac{n}{N_{ss}} T_s + \theta_m\right)},$$

Bilden eines Vektors durch Stapeln der Samples $b_{m,n}$ für jeden der $M_c$ Träger, durch:

$$\underline{S}_m = \begin{bmatrix} b_{m,0} & b_{m,1} & \cdots & b_{m,NN_{ss}-1} \end{bmatrix}^T,$$

Bilden und Skalieren eines zusammengesetzten Vektors $\underline{\zeta}$ auf einen korrekten Eingangs-Backoff-Pegel, IOB, des Hochleistungsverstärkers (121), HPA, durch:

$$\underline{\zeta} = \gamma_{IBO} \cdot \sum_{m=1}^{M_c} \underline{S}_m,$$

Berechnen von AM/AM und AM/PM Verzerrungen, die durch ein entsprechendes HPA Umwandlungsmodell konfiguriert sind und auf jedes der Samples von $\underline{\zeta}$ angewendet werden, die das verzerrte Sample $\tilde{\zeta}_n$ bilden, durch:

$$\tilde{\zeta}_n = \alpha_{TWTA}(|\zeta_n|) \cdot e^{j\left(\angle \zeta_n + \psi_{TWTA}(|\zeta_n|)\right)},$$

wobei $0 \leq n < N \cdot N_{ss}$, und $|\zeta_n|$ und $<_{\zeta_n}$ die Amplitude bzw. Phase des Eingangs $\zeta_n$ sind, und $a_{TWTA}(x)$ und $\psi_{TWTA}(x)$ die Amplituden- bzw. Phasenverzerrung des HPA Modells sind,
Nachbilden der Auswirkung einer Kaskade von Ausgangs-Multiplexing, OMUX, und Empfangsfiltern $(107_1, ..., 107M_c)$ zur Bildung der entsprechenden Vektoren:

$$\underline{\rho}(n; L, N_{ss}) = \begin{bmatrix} \tilde{\zeta}_{n-\frac{L-1}{2}N_{ss}} & \tilde{\zeta}_{n-\frac{L-1}{2}N_{ss}+1} & \cdots & \tilde{\zeta}_{n+\frac{L-1}{2}N_{ss}} \end{bmatrix}^T,$$

was einen Vektor von Filterkoeffizienten $\ddot{p}_m$ wiedergibt, der die Kaskade des Empfangsfilters $p_{m,R}$ und des OMUX-Modells darstellt,
Verarbeiten des Vektors $\underline{\rho}(n; L, N_{ss})$ durch das Filter $\ddot{p}_{md}$ und frequenzumgesetzt auf den gewünschten $m_d^{ten}$ Kanal, dessen Verzerrung geschätzt wird durch:

$$u_{m_d,n} = \left(\underline{\ddot{p}}_{m_d}^T \cdot \underline{\rho}(n; L, N_{ss})\right) \cdot e^{-j\left(2\pi f_{m_d} \frac{n}{N_{ss}} T_s + \theta_{m_d}\right)},$$

Bilden des Vektors $\underline{U}_{m_d}$ durch Stapeln lediglich der Samples von $u_{md,n}$, die durch $N_{ss}$, beabstandet sind, durch

$$\underline{U}_{m_d} = \begin{bmatrix} u_{m_d,0} & u_{m_d,N_{ss}} & \cdots & u_{m_d,(N-1)N_{ss}} \end{bmatrix}^T,$$

wobei die Intermodulationsverzerrung bestimmt wird durch: $\underline{\mathcal{H}}_{m_d}(\underline{\alpha}^{(s)}) = \underline{U}_{m_d}/\gamma_{m_d}$, wobei $\gamma_{md}$ eine komplexwertige Verstärkungskorrektur wiedergibt, die zur Beseitigung des Effekts der durch die IMD-Verzerrung bewirkten Verwerfung konfiguriert ist, die bestimmt wird durch:

$$\gamma_{m_d} = \underline{U}^T_{m_d} \cdot \underline{a}^*_{m_d};$$

und wobei die weiteren vorverzerrten Versionen aller Quellensignale zur Verarbeitung über die nächste Stufe rückgekoppelt werden.

2. Verfahren nach Anspruch 1, wobei das Verarbeiten der zuvor vorverzerrten Version des Quellensignals, die durch die empfangenen, zuvor vorverzerrten Versionen aller codierten und modulierten Quellensignale aus der vorhergehenden Stufe konfiguriert ist, das Erzeugen eines durch die Verzerrungsabschätzung konfigurierten Fehlersignals aufweist.

3. Verfahren nach Anspruch 2, wobei das Fehlersignal durch Anwendung der Schätzung über den iterativen Prozess gegen Null gesteuert wird.

4. Verfahren nach Anspruch 1, wobei die Verzerrungsabschätzung als ein Vektor dargestellt ist, der durch eine Vektordarstellung der weiteren vorverzerrten Versionen für jedes der Quellensignale konfiguriert ist, und die Verzerrungsabschätzung zur Erzeugung eines Fehlervektors für das Quellensignal bezüglich einer unverzerrten Version des codierten und modulierten Quellensignals eingesetzt wird.

5. Verfahren nach Anspruch 4, wobei der Fehlervektor für das Quellensignal durch Abzug des Verzerrungsabschätzungsvektors von der unverzerrten Version des codierten und modulierten Quellensignals erzeugt wird.

6. Verfahren nach Anspruch 5, wobei der Fehlervektor für das Quellensignal durch den iterativen Vorverzerrungsprozess gegen Null gesteuert wird.

7. Verfahren nach Anspruch 1, wobei die Modifikation des Vektors von Datensymbolen, der die vorverzerrte Version des Quellensignals aus der vorhergehenden Stufe darstellt, konfiguriert durch den Korrekturterm folgendes aufweist:

Verarbeiten des Fehlervektors, der die geschätzte Vorverzerrung darstellt, die durch die Verzerrungsabschätzung konfiguriert ist, welche sich aus dem Durchleiten des zusammengesetzten Signals durch den Mehrträgerkanal ergeben würde, konfiguriert durch eine Schrittgrößenfolge, um einen modifizierten Fehlervektor zu erzeugen; und
Hinzufügen des modifizierten Fehlervektors zu dem Vektor von Datensymbolen, der die vorverzerrte Version des Quellensignals aus der vorhergehenden Stufe darstellt, um die weitere vorverzerrte Version des Quellensignals zu erzeugen.

8. Verfahren nach Anspruch 7, wobei die Schrittgrößenfolge als positiv und abnehmend definiert wird, um den Fehlervektor gegen Null zu steuern.

9. Verfahren nach Anspruch 7, wobei die Schrittgrößenfolge dazu dient, die Durchführung des Vorverzerrungsprozesses zu optimieren, indem die Konvergenzgeschwindigkeit maximiert, die Anzahl von Vorverzerrerstufen reduziert und gleichzeitig der Restfehler minimiert wird.

10. Sendevorrichtung mit:

einer Empfängerschnittstelle, die zum Empfangen einer Vielzahl von Quellensignalen konfiguriert ist, wobei jedes Quellensignal eine Folge von Quellendatensymbolen aufweist;
einer Codiereinrichtung ($101_1...101_{MC}$) und einem Modulator ($103_1...103_{MC}$), die zum Codieren und Modulieren jedes Quellensignals zur Übertragung über einen Mehrträgerkanal (114) eines drahtlosen Kommunikationssystems (130) konfiguriert sind;
einem Prozessor, der zum Erzeugen einer endgültigen vorverzerrten Version für jedes codierte und modulierte Quellensignal konfiguriert ist;
einem Übertragungsfilter, das zum Filtern auf die endgültige vorverzerrte Version jedes der Quellensignale konfiguriert ist;
einem Signalprozessor (803), der zum Umsetzen jedes der gefilterten Signale auf eine entsprechende Trägerfrequenz konfiguriert ist; sowie
einer Signalkombiniereinrichtung, die zum Kombinieren der umgesetzten Signale konfiguriert ist, um ein zusammengesetztes Signal zur Übertragung über den Mehrträgerkanal (114) zu erzeugen;

wobei der Prozessor (803) dazu konfiguriert ist, die endgültige vorverzerrte Version für jedes codierte und modulierte Quellensignal über einen iterativen Prozess einer Anzahl von Stufen s zu erzeugen, wobei der Prozess für eine vorgegebene Stufe und für jedes Quellensignal folgendes aufweist:

Empfangen einer entsprechenden, zuvor vorverzerrten Version von jedem der Quellensignale aus einer vorhergehenden Stufe; und
Verarbeiten der zuvor vorverzerrten Version des Quellensignals, das durch die empfangenen, zuvor vorverzerrten Versionen aller Quellensignale aus der vorhergehenden Stufe konfiguriert ist,

wobei für jedes Quellensignal und für die vorgegebene Stufe des iterativen Prozesses zur Erzeugung der endgültigen vorverzerrten Version für jedes der codierten und modulierten Quellensignale:
die vorverzerrte Version jedes der Quellensignale aus der vorhergehenden Stufe als ein Vektor von Datensymbolen $\underline{a}^{(s)}$ dargestellt ist, der der entsprechenden Trägerfrequenz zugeordnet ist;
eine weitere vorverzerrte Version des Quellensignals erzeugt wird, indem der Vektor von Datensymbolen $\underline{a}^{(s)}$, der die vorverzerrte Version des Quellensignals aus der vorhergehenden Stufe darstellt, durch einen Korrekturterm konfiguriert modifiziert wird, wobei der Korrekturterm proportional zu einem Fehlervektor $\underline{e}_{m_d}^{(s)}$ ist, der eine geschätzte Vorverzerrung darstellt, die durch eine Verzerrungsabschätzung konfiguriert ist, welche durch eine Schätzung der Intermodulationsverzerrungseffekte aller benachbarten Träger, die sich den Mehrträgerkanal (114) teilen, durchgeführt wird;
wobei die Verzerrungsschätzung folgendes aufweist:

Verarbeiten von Datensymbolen jedes Trägers aus der vorhergehenden Stufe $\underline{a}_{m,n}^{(s)}$ durch ein Interpolationsfilter, das die Kaskade des übertragenen Datenimpulses und des Eingangsmultiplexfilters, IMUX, modelliert, bezeichnet als Vektor $\underline{a}_m^{(s)}(n; L, N_{ss})$, unter Verwendung der in $\underline{a}^{(s)}$ enthaltenen Datensymbole, durch

$$\underline{a}_m^{(s)}(n; L, N_{ss}) = \left[ a_{m,n-\frac{L-1}{2}}^{(s)} \ \underline{0}_{N_{ss}-1} \ a_{m,n-\frac{L-1}{2}+1}^{(s)} \ \underline{0}_{N_{ss}-1} \ \cdots \ a_{m,n+\frac{L-1}{2}}^{(s)} \ \underline{0}_{N_{ss}-1} \right]^T,$$

wobei $N_{ss}$ den Eingangsvektor an Mehrfachsamples pro Symbol wiedergibt, $\underline{0}_K$ den Alles-Null-Vektor der Länge $K$ wiedergibt, und $L$ die beidseitige Speicherspanne des Vorverzerrers wiedergibt,

Verarbeiten des Vektors $\underline{a}_m^{(s)}(n; L, N_{ss})$ für jeden Träger durch einen Vektor von Filterkoeffizienten $\dot{\underline{p}}_m$, der die Kaskade des Übertragungsfilters (107) und des IMUX-Modells darstellt und auf die entsprechende Mittelfrequenz des entsprechenden Trägers, des $m^{ten}$ Trägers, frequenzumgesetzt ist, durch:

$$b_{m,n} = \left( \dot{\underline{p}}_m^T \cdot \underline{a}_m^{(s)}(n; L, N_{ss}) \right) \cdot e^{j\left( 2\pi f_m \frac{n}{N_{ss}} T_s + \theta_m \right)},$$

Bilden eines Vektors durch Stapeln der Samples $b_{m,n}$ für jeden der $M_c$ Träger, durch:

$$\underline{S}_m = \left[ b_{m,0} \ b_{m,1} \ \cdots \ b_{m,NN_{ss}-1} \right]^T,$$

Bilden und Skalieren eines zusammengesetzten Vektors $\underline{\zeta}$ auf einen korrekten Eingangs-Backoff-Pegel, IOB, des Hochleistungsverstärkers (121), HPA, durch:

$$\underline{\zeta} = \gamma_{IBO} \cdot \sum_{m=1}^{M_c} \underline{S}_m,$$

Berechnen von AM/AM und AM/PM Verzerrungen, die durch ein entsprechendes HPA Umwandlungsmodell konfiguriert sind und auf jedes der Samples von $\underline{\zeta}$ angewendet werden, die das verzerrte Sample $\zeta_n$ bilden,

durch:

$$\tilde{\zeta}_n = a_{TWTA}(|\zeta_n|) \cdot e^{j\left(\angle \zeta_n + \psi_{TWTA}(|\zeta_n|)\right)},$$

wobei $0 \leq n < N \cdot N_{ss}$, und $|\zeta_n|$ und $\angle \zeta_n$ die Amplitude bzw. Phase des Eingangs $\zeta_n$ sind, und $a_{TWTA}(x)$ und $\psi_{TWTA}(x)$ die Amplituden- bzw. Phasenverzerrung des HPA Modells sind,

Nachbilden der Auswirkung einer Kaskade von Ausgangs-Multiplexing, OMUX, und Empfangsfiltern ($107_1$, ..., $107_{Mc}$) zur Bildung der entsprechenden Vektoren:

$$\underline{\rho}(n; L, N_{ss}) = \left[\tilde{\zeta}_{n-\frac{L-1}{2}N_{ss}} \quad \tilde{\zeta}_{n-\frac{L-1}{2}N_{ss}+1} \quad \cdots \quad \tilde{\zeta}_{n+\frac{L-1}{2}N_{ss}}\right]^T,$$

was einen Vektor von Filterkoeffizienten $\underline{\ddot{p}}_m$ wiedergibt, der die Kaskade des Empfangsfilters $p_{m,R}$ und des OMUX-Modells darstellt,

Verarbeiten des Vektors $\rho(n; L, N_{ss})$ durch das Filter $\underline{\ddot{p}}_{md}$ und frequenzumgesetzt auf den gewünschten $m_d{}^{ten}$ Kanal, dessen Verzerrung geschätzt wird durch:

$$u_{m_d,n} = \left(\underline{\ddot{p}}_{m_d}^T \cdot \underline{\rho}(n; L, N_{ss})\right) \cdot e^{-j\left(2\pi f_{m_d}\frac{n}{N_{ss}}T_s + \theta_{m_d}\right)},$$

Bilden des Vektors $\underline{\mathcal{U}}_{m_d}$ durch Stapeln lediglich der Samples von $u_{md,n}$, die durch $N_{ss}$ beabstandet sind, durch

$$\underline{\mathcal{U}}_{m_d} = \left[u_{m_d,0} \quad u_{m_d,N_{ss}} \quad \cdots \quad u_{m_d,(N-1)N_{ss}}\right]^T,$$

wobei die Intermodulationsverzerrung bestimmt wird durch: $\mathcal{H}_{m_d}\left(\underline{\alpha}^{(s)}\right) = \underline{\mathcal{U}}_{m_d}/\gamma_{m_d}$, wobei $\gamma_{md}$ eine komplexwertige Verstärkungskorrektur wiedergibt, die zur Beseitigung des Effekts der durch die IMD-Verzerrung bewirkten Verwerfung konfiguriert ist, welche bestimmt wird durch:

$$\gamma_{m_d} = \underline{\mathcal{U}}_{m_d}^T \cdot \underline{\alpha}_{m_d}^*;$$

und wobei die weiteren vorverzerrten Versionen aller Quellensignale zur Verarbeitung über die nächste Stufe rückgekoppelt werden.

11. Verfahren nach Anspruch 10, wobei das Verarbeiten der zuvor vorverzerrten Version des Quellensignals, die durch die empfangenen, zuvor vorverzerrten Versionen aller codierten und modulierten Quellensignale aus der vorhergehenden Stufe konfiguriert ist, das Erzeugen eines durch die Verzerrungsabschätzung konfigurierten Fehlersignals aufweist.

12. Verfahren nach Anspruch 11, wobei das Fehlersignal durch Anwendung der Schätzung über den iterativen Prozess gegen Null gesteuert wird.

13. Verfahren nach Anspruch 10, wobei die Verzerrungsabschätzung als ein Vektor dargestellt ist, der durch eine Vektordarstellung der weiteren vorverzerrten Versionen für jedes der Quellensignale konfiguriert ist, und die Verzerrungsabschätzung zur Erzeugung eines Fehlervektors für das Quellensignal bezüglich einer unverzerrten Version des codierten und modulierten Quellensignals eingesetzt wird.

14. Verfahren nach Anspruch 13, wobei der Fehlervektor für das Quellensignal durch Abzug des Verzerrungsabschätzungsvektors von der unverzerrten Version des codierten und modulierten Quellensignals erzeugt wird.

15. Verfahren nach Anspruch 14, wobei der Fehlervektor für das Quellensignal durch den iterativen Vorverzerrungsprozess gegen Null gesteuert wird.

**16.** Verfahren nach Anspruch 10, wobei die Modifikation des Vektors von Datensymbolen, der die vorverzerrte Version des Quellensignals aus der vorhergehenden Stufe darstellt, konfiguriert durch den Korrekturterm folgendes aufweist:

Verarbeiten des Fehlervektors, der die geschätzte Vorverzerrung darstellt, die durch die Verzerrungsabschätzung konfiguriert ist, welche sich aus dem Durchleiten des zusammengesetzten Signals durch den Mehrträgerkanal ergeben würde, konfiguriert durch eine Schrittgrößenfolge, um einen modifizierten Fehlervektor zu erzeugen; und

Hinzufügen des modifizierten Fehlervektors zu dem Vektor von Datensymbolen, der die vorverzerrte Version des Quellensignals aus der vorhergehenden Stufe darstellt, um die weitere vorverzerrte Version des Quellensignals zu erzeugen.

**17.** Verfahren nach Anspruch 16, wobei die Schrittgrößenfolge als positiv und abnehmend definiert wird, um den Fehlervektor gegen Null zu steuern.

**18.** Verfahren nach Anspruch 16, wobei die Schrittgrößenfolge dazu dient, die Durchführung des Vorverzerrungsprozesses zu optimieren, indem die Konvergenzgeschwindigkeit maximiert, die Anzahl von Vorverzerrerstufen reduziert und gleichzeitig der Restfehler minimiert wird.


**Revendications**

**1.** Procédé comportant :

la réception d'une pluralité de signaux source, dans lequel chaque signal source comporte une séquence de symboles de données source ;
le codage et la modulation de chaque signal source en vue d'une transmission via un canal à porteuses multiples (114) d'un système de communication sans fil (130) ;
la génération d'une version prédéformée finale pour chaque signal source codé et modulé ;
l'application d'un filtre d'émission (107) à la version prédéformée finale de chacun des signaux source ;
la transposition de chacun des signaux filtrés sur une fréquence porteuse respective ; et
la combinaison des signaux transposés pour générer un signal composite en vue d'une transmission via le canal à porteuses multiples (114) ;
dans lequel la version prédéformée finale pour chacun des signaux source codés et modulés est générée via un processus itératif constitué d'un certain nombre d'étapes, dans lequel, pour une étape donnée et pour chaque signal source,
le processus comporte :

la réception d'une version prédéformée antérieure respective de chacun des signaux source issus d'une étape précédente ; et
le traitement de la version prédéformée antérieure du signal source configuré par les versions prédéformées antérieures reçues de tous les signaux source issus de l'étape précédente,

dans lequel, pour chaque signal source et pour les étapes données du processus itératif destiné à la génération de la version prédéformée finale pour chacun des signaux source codés et modulés :

la version prédéformée de chacun des signaux source issus de l'étape précédente est représentée sous la forme d'un vecteur de symboles de données $\alpha^{(s)}$ associés à la fréquence porteuse respective ;
une version prédéformée supplémentaire du signal source est générée en modifiant le vecteur de symboles de données $\underline{\alpha}^{(s)}$, représentant la version prédéformée du signal source issu de l'étape précédente, configuré par un terme de correction, dans lequel le terme de correction est proportionnel à un vecteur d'erreur $\underline{e}_{m,d}^{(s)}$, représentant une prédistorsion estimée configurée par une estimation de distorsion qui est réalisée par une estimation des effets de distorsion d'intermodulation de toutes les porteuses adjacentes partageant le canal à porteuses multiples (114) ;
dans lequel l'estimation de distorsion comporte :

le traitement des symboles de données de chaque porteuse issue de l'étape précédente $\underline{a}_{m,n}^{(s)}$ par

l'intermédiaire d'un filtre d'interpolation, qui modélise la cascade du filtre d'impulsions de données transmises et du filtre multiplexeur d'entrée, IMUX, représenté par le vecteur $\underline{a}_m^{(s)}(n; L, N_{ss})$, en utilisant les symboles de données contenus dans $\underline{a}^{(s)}$, par

$$\underline{a}_m^{(s)}(n; L, N_{ss}) = \left[ a_{m,n-\frac{L-1}{2}}^{(s)} \; \underline{0}_{N_{ss}-1} \; a_{m,n-\frac{L-1}{2}+1}^{(s)} \; \underline{0}_{N_{ss}-1} \; \cdots \; a_{m,n+\frac{L-1}{2}}^{(s)} \; \underline{0}_{N_{ss}-1} \right]$$

dans lequel $N_{ss}$ représente le vecteur d'entrée à des échantillons multiples par symbole, $\underline{0}_k$ représente le vecteur nul de longueur $K$, et $L$ représente l'intervalle de mémoire bilatéral du pré-générateur de distorsion,

le traitement du vecteur $\underline{a}_m^{(s)}(n; L, N_{ss})$ pour chaque porteuse par un vecteur de coefficients de filtre $\dot{p}_m$, représentant la cascade du filtre d'émission (107) et du modèle d'IMUX,
et transposé en fréquence sur la fréquence centrale respective de la porteuse respective, la $m^{th}$ porteuse, par :

$$b_{m,n} = \left( \underline{\dot{p}}_m^T \cdot \underline{a}_m^{(s)}(n; L, N_{ss}) \right) \cdot e^{j\left(2\pi f_m \frac{n}{N_{ss}} T_s + \theta_m\right)}$$

la formation d'un vecteur en empilant les échantillons $h_{m,n}$ pour chacune des $M_c$ porteuses, par :

$$\underline{S}_m = \left[ b_{m,0} \; b_{m,1} \; \cdots \; b_{m,N N_{ss}-1} \right]^T,$$

la formation et la mise à l'échelle d'un vecteur composite $\underline{\zeta}$ jusqu'à un niveau de recul à l'entrée correct, IOB, de l'amplificateur à grande puissance (121), HPA, par :

$$\underline{\zeta} = \gamma_{IBO} \cdot \sum_{m=1}^{M_c} \underline{S}_m,$$

le calcul des distorsions AM/AM et AM/PM configurées par un modèle de conversion de HPA correspondant et appliquées à chacun des échantillons de $\underline{\zeta}$ produisant l'échantillon déformé $\tilde{\zeta}_n$ par :

$$\tilde{\zeta}_n = \alpha_{TWTA}\left(|\zeta_n|\right) \cdot e^{j\left(\angle \zeta_n + \Psi_{TWTA}(|\zeta_n|)\right)},$$

dans lequel $0 \leq n < N \cdot N_{ss}$ et $|\zeta_n|$ et $\angle_{\zeta_n}$ sont l'amplitude et la phase de l'entrée $\zeta_n$, respectivement, et $u_{TWTA}(x)$ et $\Psi_{TWTA}(x)$ sont la distorsion d'amplitude et la distorsion de phase, respectivement, du modèle de HPA,
la réplication de l'impact d'une cascade de filtres multi-plexeurs de sortie, OMUX, et de réception $(107_1,...,107_{Mc})$ pour former les vecteurs respectifs :

$$\underline{\rho}(n; L, N_{ss}) = \left[ \tilde{\zeta}_{n-\frac{L-1}{2}N_{ss}} \; \tilde{\zeta}_{n-\frac{L-1}{2}N_{ss}+1} \; \cdots \; \tilde{\zeta}_{n+\frac{L-1}{2}N_{ss}} \right]^T,$$

qui représente un vecteur de coefficients de filtre $\ddot{p}_m$, représentant la cascade du filtre de réception $p_{m,k}$ et du modèle d'OMUX,
le traitement du vecteur $\underline{\rho}(n; L, N_{ss})$ par le filtre $\underline{\ddot{p}}_{md}$ et transposé en fréquence sur le $m_a^{th}$ canal voulu, dont la distorsion est estimée par :

$$u_{m_d,n} = \left( \underline{\ddot{p}}_{m_d}^T \cdot \underline{\rho}(n; L, N_{ss}) \right) \cdot e^{-j\left( 2\pi f_{m_d} \frac{n}{N_{ss}} T_s + \theta_{m_d} \right)},$$

la formation du vecteur $\underline{\mathcal{U}}_{m_d}$ en empilant uniquement les échantillons de $u_{md.n}$ qui sont espacées de $N_{ss}$, par

$$\underline{\mathcal{U}}_{m_d} = \left[ u_{m_d,0} \ \ u_{m_d,N_{ss}} \ \cdots \ \ u_{m_d,(N-1)N_{ss}} \right]^T,$$

dans lequel la distorsion d'intermodulation est déterminée par : $\underline{\mathcal{H}}_{m_d}\left( \underline{a}^{(s)} \right) = \underline{\mathcal{U}}_{m_d} / \gamma_{m_d}$ , dans lequel $\gamma_{md}$, représente une correction de gain à valeur complexe configurée pour éliminer l'effet de la déformation due à la distorsion d'intermodulation, IMD, qui est déterminée par :

$$\gamma_{m_d} = \underline{\mathcal{U}}_{m_d}^T \cdot \underline{a}_{m_d}^*;$$

et dans lequel les versions prédéformées supplémentaires de tous les signaux source sont réinjectés en vue d'un traitement via l'étape suivante.

2. Procédé selon la revendication 1, dans lequel le traitement de la version prédéformée antérieure du signal source configuré par les versions prédéformées antérieures reçues de tous les signaux source codés et modulés issus de l'étape précédente comporte la génération d'un signal d'erreur configuré par l'estimation de distorsion.

3. Procédé selon la revendication 2, dans lequel le signal d'erreur est forcé vers zéro en appliquant l'estimation via le processus itératif.

4. Procédé selon la revendication 1, dans lequel l'estimation de distorsion est représenté sous la forme d'un vecteur configuré par une représentation vectorielle des versions prédéformées supplémentaires pour chacun des signaux source, et l'estimation de distorsion est utilisée pour générer un vecteur d'erreur pour le signal source par rapport à une version non déformée du signal source codé et modulé.

5. Procédé selon la revendication 4, dans lequel le vecteur d'erreur du signal source est généré en soustrayant le vecteur d'estimation de distorsion de la version non déformée du signal source codé et modulé.

6. Procédé selon la revendication 5, dans lequel le vecteur d'erreur pour le signal source est forcé vers zéro par le processus de prédistorsion itératif.

7. Procédé selon la revendication 1, dans lequel la modification du vecteur de symboles de données, représentant la version prédéformée du signal source issu de l'étape précédente, configuré par le terme de correction, comporte :

le traitement du vecteur d'erreur, représentant la prédistorsion estimée configurée par l'estimation de distorsion qui résulterait du passage du signal composite par le canal à porteuses multiples, configuré par une séquence de pas de progression pour générer un vecteur d'erreur modifié ; et
l'addition du vecteur d'erreur modifié au vecteur de symboles de données, représentant la version prédéformée du signal source issu de l'étape précédente, pour générer la version prédéformée supplémentaire du signal source.

8. Procédé selon la revendication 7, dans lequel la séquence de pas de progression est définie pour être positive et diminuer de manière à forcer le vecteur d'erreur vers zéro.

9. Procédé selon la revendication 7, dans lequel la séquence de pas de progression sert à optimiser les performances du processus de prédistorsion en maximisant la vitesse de convergence, la réduction du nombre d'étapes de pré-générateur de distorsion, tout en minimisant l'erreur résiduelle.

10. Appareil d'émission comportant :

une interface de réception configurée pour recevoir une pluralité de signaux source, dans lequel chaque signal source comporte une séquence de symboles de données source ;

un codeur ($101_1$...$101_{MC}$) et un modulateur ($103_1$...$103_{Mc}$) configurés pour coder et moduler chaque signal source en vue d'une transmission via un canal à porteuses multiples (114) d'un système de communication sans fil (130) ;

un processeur configuré pour générer une version prédéformée finale pour chaque signal source codé et modulé ;

un filtre d'émission configuré pour filtrer la version prédéformée finale de chacun des signaux source ;

un processeur de signal (803) configuré pour transposer chacun des signaux filtrés sur une fréquence porteuse respective ; et

un combineur de signaux configuré pour combiner les signaux transposés pour générer un signal composite en vue d'une transmission via le canal à porteuses multiples (114) ;

dans lequel le processeur (803) est configuré pour générer la version prédéformée finale pour chaque signal source codé et modulé via un processus itératif constitué d'un certain nombre d'étapes, dans lequel, pour une étape donnée et pour chaque signal source, le processus comporte :

la réception d'une version prédéformée antérieure respective de chacun des signaux source issus d'une étape précédente ; et

le traitement de la version prédéformée antérieure du signal source configuré par les versions prédéformées antérieures reçues de tous les signaux source issus de l'étape précédente,

dans lequel, pour chaque signal source et pour l'étape donnée du processus itératif destiné à la génération de la version prédéformée finale pour chacun des signaux source codés et modulés :

la version prédéformée de chacun des signaux source issus de l'étape précédente est représentée sous la forme d'un vecteur de symboles de données $\underline{\alpha}^{(s)}$ associé à la fréquence porteuse respective ;

une version prédéformée supplémentaire du signal source est générée en modifiant le vecteur de symboles de données $\alpha^{(s)}$, représentant la version prédéformée du signal source issu de l'étape précédente, configuré par un terme de correction, dans lequel le terme de correction est proportionnel à un vecteur d'erreur $\underline{e}_{m_d}^{(s)}$, représentant une prédistorsion estimée configurée par une estimation de distorsion qui est réalisée par une estimation des effets de la distorsion d'intermodulation de toutes les porteuses adjacentes partageant le canal à porteuses multiples ;

dans lequel l'estimation de distorsion comporte :

le traitement des symboles de données de chaque porteuse issue de l'étape précédente $\underline{a}_{m,n}^{(s)}$ par l'intermédiaire d'un filtre d'interpolation, qui modélise la cascade du filtre d'impulsions de données transmises et du filtre multi-plexeur d'entrée, IMUX, représenté par le vecteur $\underline{a}_m^{(s)}(n; L, N_{ss})$, en utilisant les symboles de données contenus dans $\underline{\alpha}^{(s)}$, par

$$\underline{a}_m^{(s)}(n; L, N_{SS}) = \left[ a_{m,n-\frac{L-1}{2}}^{(s)} \ \underline{0}_{N_{SS}-1} \ a_{m,n-\frac{L-1}{2}+1}^{(s)} \ \underline{0}_{N_{SS}-1} \ \cdots \ a_{m,n+\frac{L-1}{2}}^{(s)} \ \underline{0}_{N_{SS}-1} \right]^T,$$

dans lequel $N_{ss}$ représente le vecteur d'entrée à des échantillons multiples par symbole, $\underline{D}_K$ représente le vecteur nul de longueur $K$, et $L$ représente l'intervalle de mémoire bilatéral du pré-générateur de distorsion,

le traitement d'un vecteur $\underline{a}_m^{(s)}(n; L, N_{ss})$, pour chaque porteuse par un vecteur de coefficients de filtre $\dot{p}_m$, représentant la cascade du filtre d'émission (107) et du modèle d'IMUX, et transposé en fréquence sur la fréquence centrale respective de la porteuse respective, la $m^{th}$ porteuse, par :

$$b_{m,n} = \left( \underline{\ddot{p}}_m^T \cdot \underline{a}_m^{(s)}(n; L, N_{ss}) \right) \cdot e^{j\left( 2\pi f_m \frac{n}{N_{ss}} T_s + \theta_m \right)} \,,$$

la formation d'un vecteur en empilant les échantillons $h_{m,n}$ pour chacune des $M_c$ porteuses, par :

$$\underline{S}_m = \begin{bmatrix} b_{m,0} & b_{m,1} & \cdots & b_{m,NN_{ss}-1} \end{bmatrix}^T,$$

la formation et la mise à l'échelle d'un vecteur composite $\underline{\zeta}$ jusqu'à un niveau de recul à l'entrée correct, IOB, de l'amplificateur à grande puissance (121), HPA, par :

$$\underline{\zeta} = \gamma_{IBO} \cdot \sum_{m=1}^{M_c} \underline{S}_m,$$

le calcul des distorsions AM/AM et AM/PM configurées par un modèle de conversion de HPA correspondant et appliquées à chacun des échantillons de $\underline{\zeta}$ produisant l'échantillon déformé $\tilde{\zeta}_n$, par :

$$\tilde{\zeta}_n = \alpha_{TWTA}(|\zeta_n|) \cdot e^{j\left( \angle\zeta_n + \Psi_{TWTA}(|\zeta_n|) \right)},$$

dans lequel $0 \le n < N \cdot N_{ss}$ et $|\zeta_n|$ et $\angle\zeta_n$ sont l'amplitude et la phase de l'entrée $\zeta_n$, respectivement, et $\alpha_{TWTA}(x)$ et $\Psi_{TWTA}(x)$ sont la distorsion d'amplitude et la distorsion de phase, respectivement, du modèle de HPA,
la réplication de l'impact d'une cascade de filtres multi-plexeurs de sortie, OMUX, et de réception ($107_1,..., 107_{Mc}$) pour former les vecteurs respectifs :

$$\underline{\varrho}(n; L, N_{ss}) = \begin{bmatrix} \tilde{\zeta}_{n-\frac{L-1}{2}N_{ss}} & \tilde{\zeta}_{n-\frac{L-1}{2}N_{ss}+1} & \cdots & \tilde{\zeta}_{n+\frac{L-1}{2}N_{ss}} \end{bmatrix}^T,$$

qui représente un vecteur de coefficients de filtre $\ddot{p}_m$, représentant la cascade du filtre de réception $p_{m,k}$ et du modèle d'OMUX,
le traitement du vecteur $\underline{\varrho}(n; L, N_{ss})$ par le filtre $\ddot{p}_{md}$ et transposé en fréquence sur le $m_\alpha^{th}$ canal voulu, dont la distorsion est estimée par :

$$u_{m_d,n} = \left( \underline{\ddot{p}}_{m_d}^T \cdot \underline{\varrho}(n; L, N_{ss}) \right) \cdot e^{-j\left( 2\pi f_{md} \frac{n}{N_{ss}} T_s + \theta_{md} \right)},$$

la formation du vecteur $\underline{\mathcal{U}}_{m_d}$ en empilant uniquement les échantillons de $u_{md,n}$ qui sont espacées de $N_{ss}$, par

$$\underline{\mathcal{U}}_{m_d} = \begin{bmatrix} u_{m_d,0} & u_{m_d,N_{ss}} & \cdots & u_{m_d,(N-1)N_{ss}} \end{bmatrix}^T,$$

dans lequel la distorsion d'intermodulation est déterminée par : $\underline{\mathcal{H}}_{m_d}(\underline{\alpha}^{(s)}) = \underline{\mathcal{U}}_{m_d} / \gamma_{m_d}$,
dans lequel $\gamma_{md}$ représente une correction de gain à valeur complexe configurée pour éliminer l'effet de la déformation due à la distorsion d'intermodulation, IMD, qui est déterminée par :

$$\gamma_{m_d} = \underline{\mathcal{U}}_{m_d}^T \cdot \underline{a}_{m_d}^\times;$$

et dans lequel les versions prédéformées supplémentaires de tous les signaux source sont réinjectés en vue d'un traitement via l'étape suivante.

11. Appareil selon la revendication 10, dans lequel le traitement de la version prédéformée antérieure du signal source configuré par les versions prédéformées antérieures reçues de tous les signaux source codés et modulés issus de l'étape précédente comporte la génération d'un signal d'erreur configuré par l'estimation de distorsion.

12. Appareil selon la revendication 11, dans lequel le signal d'erreur est forcé vers zéro en appliquant l'estimation via le processus itératif.

13. Appareil selon la revendication 10, dans lequel l'estimation de distorsion est représentée sous la forme d'un vecteur configuré par une représentation vectorielle des versions prédéformées supplémentaires pour chacun des signaux source, et l'estimation de distorsion est utilisée pour générer un vecteur d'erreur pour le signal source par rapport à une version non déformée du signal source codé et modulé.

14. Appareil selon la revendication 13, dans lequel le vecteur d'erreur pour le signal source est généré en soustrayant le vecteur d'estimation de distorsion de la version non déformée du signal source codé et modulé.

15. Appareil selon la revendication 14, dans lequel le vecteur d'erreur pour le signal source est forcé vers zéro par le processus de prédistorsion itératif.

16. Appareil selon la revendication 10, dans lequel la modification du vecteur de symboles de données, représentant la version prédéformée du signal source issu de l'étape précédente, configuré par le terme de correction comporte :

le traitement du vecteur d'erreur, représentant la prédistorsion estimée configurée par l'estimation de distorsion qui résulterait du passage du signal composite par le canal à porteuses multiples, configuré par une séquence de pas de progression pour générer un vecteur d'erreur modifié ; et
l'addition du vecteur d'erreur modifié au vecteur de symboles de données, représentant la version prédéformée du signal source issu de l'étape précédente, pour générer la version prédéformée supplémentaire du signal source.

17. Appareil selon la revendication 16, dans lequel la séquence de pas de progression est définie pour être positive et diminuer de manière à forcer le vecteur d'erreur vers zéro.

18. Appareil selon la revendication 16, dans lequel la séquence de pas de progression sert à optimiser les performances du processus de prédistorsion en maximisant la vitesse de convergence, la réduction du nombre d'étapes de pré-générateur de distorsion, tout en minimisant l'erreur résiduelle.

FIG. 1

FIG. 2

FIG. 3

FIG. 4

FIG. 5A

MUX Group Delay Model

FIG. 5B

OMUX Amplitude Model

FIG. 5C

OMUX Group Delay Model

Group Delay (ms)

Frequency (MHz)

FIG. 5D

FIG. 5E

FIG. 5F

FIG. 6A

FIG. 6B

FIG. 7A

Scatter plot

Volterra-Based Estimation

FIG. 7B

800

| PROCESSOR 803 | DSP 807 | ASIC 809 |

BUS 801

MEMORY 805

FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8355462 B
- US 2014079160 A1

- EP 2178205 A1
- US 20020164949 A1

**Non-patent literature cited in the description**

- **B. F. BEIDAS ; R. I. SESHADRI.** Analysis and compensation for nonlinear interference of two high-order modulation carriers over satellite link. *IEEE Trans. Comm.,* June 2010, vol. 58 (6), 1824-1833
- **B. F. BEIDAS.** Intermodulation distortion in multicarrier satellite systems: Analysis and turbo volterra equalization. *IEEE Trans. Comm.,* June 2011, vol. 59 (6), 1580-1590
- **X. WANG ; H. V. POOR.** Iterative (Turbo) soft interference cancellation and decoding for coded CDMA. *IEEE Trans. Comm.,* July 1999, vol. 47 (7), 1046-1061
- **H. EI-GAMAL ; E. GERANIOTIS.** Iterative multiuser detection for coded CDMA in AWGN and fading channels. *IEEE J. Select. Areas Comm.,* January 2000, vol. 18 (1), 30-41
- **B. F. BEIDAS ; H. EI-GAMAL ; S. KAY.** Iterative interference cancellation for high spectral efficiency satellite communications. *IEEE Trans. Comm.,* January 2002, vol. 50 (1), 31-36
- **G. KARAM ; H. SARI.** Analysis of predistortion, equalization, and ISI cancellation techniques in digital radio systems with nonlinear transmit amplifiers. *IEEE Trans. Comm.,* December 1989, vol. 37 (12), 1245-1253
- **L. GIUGNO ; M. LUISE ; V. LOTTICI.** Adaptive pre- and post-compensation of nonlinear distortions for high-level data modulations. *IEEE Trans. Wireless Comm.,* September 2004, vol. 3 (5), 1490-1495

- **R. DE GAUDENZI ; A. G. FABREGAS ; A. MARTIN-EZI.** Performance analysis of turbo-coded APSK modulations over nonlinear satellite channels. *IEEE Trans. Wireless Comm.,* September 2006, vol. 5 (9), 2396-2407
- **E. BIGLIERI ; S. BARBERIS ; M. CATENA.** Analysis and compensation of nonlinearities in digital transmission systems. *IEEE J. Select. Areas Comm.,* January 1988, vol. 6 (1), 42-51
- **C. EUN ; E. POWERS.** A new volterra predistorter based on the indirect learning architecture. *IEEE Trans. Signal Process.,* January 1997, vol. 45 (1), 223-227
- **L. DING ; G. ZHOU ; D. MORGAN ; M. ZHENGXIANG ; J. KENNEY ; K. JAEHYEONG ; C. GIARDINA.** A robust digital baseband predistorter constructed using memory polynomials. *IEEE Trans. Comm.,* January 2004, vol. 52 (1), 159-165
- **G. KARAM ; H. SARI.** A data predistortion technique with memory for QAM radio systems. *IEEE Trans. Comm.,* February 1991, vol. 39 (2), 336-344
- **E. CASINI ; R. DE GAUDENZI ; A. GINESI.** DVB-S2 modem algorithms design and performance over typical satellite channels. *Int'l J. on Satellite Comm. and Networking,* 2004, vol. 22 (2), 281-318
- **R. PIAZZA ; M. R. BHAVANI SHANKAR ; E. ZENTENO ; D. RONNOW ; J. GROTZ ; F. ZIMMER ; M. GRASSLIN ; F. HECKMANN ; S. CIONI.** Multicarrier digital predistortion/equalization techniques for nonlinear satellite channels. *Proc. 30th AIAA Int'l Comm. Satellite System Conference (ICSSC),* September 2012
- **S. HAYKIN.** Adaptive Filter Theory. Prentice-Hall, 1991